# EUROPÄISCHE PATENTSCHRIFT

(11) **EP 0 600 051 B1**
(45) Veröffentlichungstag und Bekanntmachung des Hinweises auf die Patenterteilung: **12.05.1999**
(21) Anmeldenummer: 93909754.9
(22) Anmeldetag: 09.06.1993
(51) Int. Cl.: H05K 3/00, H05K 3/42, H05K 3/46

(54) **VERFAHREN ZUR HERSTELLUNG VON LEITERPLATTEN UNTER VERWENDUNG EINES HALBZEUGES MIT EXTREM DICHTER VERDRAHTUNG FÜR DIE SIGNALFÜHRUNG**
PROCESS FOR PRODUCING PRINTED CIRCUIT BOARDS USING A SEMI-FINISHED PRODUCT WITH EXTREMELY DENSE WIRING FOR SIGNAL CONDUCTION
PROCEDE DE FABRICATION DE CARTES DE CIRCUITS IMPRIMES A L'AIDE D'UN PRODUIT SEMI-FINI AYANT UN CABLAGE EXTREMEMENT DENSE POUR LA CONDUCTION DE SIGNAUX

(30) Priorität: 15.06.1992 CH 1872/92; 15.06.1992 GB 9212648; 15.06.1992 CH 1878/92; 01.04.1993 CH 1017/93; 06.04.1993 CH 1050/93; 02.06.1993 CH 1639/93
(43) Veröffentlichungstag der Anmeldung: 08.06.1994
(73) Patentinhaber: DYCONEX PATENTE AG, 6300 Zug (CH)
(72) Erfinder: SCHMIDT, Walter, CH-8050 Zürich (CH); MARTINELLI, Marco, CH-8413 Neftenbach (CH)
(74) Vertreter: Frei, Alexandra Sarah
(86) Internationale Anmeldenummer: CH9300145
(87) Internationale Veröffentlichungsnummer: WO9326143

(56) Entgegenhaltungen:
- EP-A- 0 154 909
- EP-A- 0 275 686
- EP-A- 0 283 546
- EP-A- 0 451 541
- FR-A- 1 574 301
- FR-A- 2 117 172
- GB-A- 2 163 007
- US-A- 3 820 994
- US-A- 4 118 523
- US-A- 4 830 691
- G.LEONIDA: 'Handbook of Printed Circuit Design, Manufacture, Components & Assembly', 1981, Seiten 210-219, ELECTROCHEMICAL PUBLICATIONS INC.

## Beschreibung

Die Erfindung liegt auf dem Gebiete der Herstellung von Leiterplatten und betrifft ein Verfahren zur Herstellung eines Halbzeugs zur Verwendung in der Leiterplattenfabrikation, sowie ein von Rolle-zu-Rolle verlaufendes Verfahren zur Herstellung von Leiterplatten unter Verwendung von Halbzeugen gemäss Erfindung.

Leiterplatten sind seit der Frühzeit der Elektrotechnik bekannte einlagige oder mehrlagige "gedruckte" Schaltungen, welche aus einer Kombination flacher Strompfade (Verbindungen der elektronischen Schaltung) und einer Isolierplatte (dem elektrisch isolierenden mechanischen Träger) bestehen. Die Strukturierung der Schaltung (Layout) erfolgt mittels photochemischer Verfahren. Abgesehen von der Surface-Mounted-Device- oder SMD-Technik weisen die Leiterplatten Durchgänge auf, die einerseits zur Durchsteck-Bestückung (elektrische Kontaktierung und mechanische Befestigung) einfacher elektronischer Bauelemente (wie Widerstände, Kondensatoren, Spulen etc.) dienen und andererseits Strompfade verschiedener Lagen einer Leiterplatte über Durchplattierungen elektrisch miteinander verbinden.

Die Entwicklung komplexer Schaltungen dagegen erfolgte auf der Ebene der integrierten Schaltkreise (Integrated Circuits (ICs)), welche aus einer grossen Anzahl elektronischer Elemente (Transistoren) auf einem gemeinsamen Substrat bestehen und durch ein Gehäuse geschützt sind (Chips). Diese Chips weisen eine sehr hohe und ständig wachsende Verdichtung an Schaltungen auf, was weitgehend durch Miniaturisierung bzw. Reduzierung der Leiterbahndicken und Leiterbahnenabstände im Si-Substrat in einem Sub-µm-Bereich geschieht. Die Gehäusedimension solcher Chips bleibt zur einfachen Handhabung allerdings in der Grössenordnung der oben erwähnten einfachen Bauelemente, auch die Dimension der Leiterplatte und ihrer Löcher bzw. Durchplattierungen blieb im wesentlichen unverändert. Somit erfolgt die Miniaturisierung von Schaltungen in erster Linie über integrierte Schaltungen, welche an sich selbständige, funktionengebundene Einheiten darstellen, die einfach auf Leiterplatten zu bestücken sind.

Die strukturelle Dimensionierung von Leiterplatten hat sichtbar an dieser Miniaturisierung nur unvollständig teilgenommen. Eine gewisse Miniaturisierung der Leiterplatten mit der klassischen Technik erfolgte wohl, dies allerdings weniger durch rigorose Verdichtung als durch möglichstes Schmalermachen der Leiterbahnen. Wesentliche Fortschritte hierbei wurden aber rasch durch die unverzichtbaren Durchplattierungen behindert, welche bislang zwar Gegenstand von Präzisionsverbesserungen, nicht aber einer Miniaturisierung waren. Der Grund hierfür liegt daran, dass die Leiterplattendurchplattierungen eine strukturell bedingte untere Grenze erreicht haben, man kann sie nicht weiter verkleinern, da, nebst der Grenze der Bohrdurchmesser, vor allen Dingen die Lötaugen und die vorbereiteten Lötflächen sehr viel Platz beanspruchen. Wünschbar wäre aber, Substrate (Leiterplatten) mit 10-fach höherer Dichte herstellen zu können, was mit der graduellen Miniaturisierung der klassischen Technik jedoch nicht mehr möglich ist. Dieser Sprung in der Dimensionierung über eine Grössenordnung führt zu Zielkonflikten.

Leiterplatten, Prepregs und auch Leiterfolien sind meistens 0,1 bis 1 oder 2mm dick, ihre Lochdurchmesser betragen gezwungenermassen 0,2 bis 0,5mm. Solche Dimensionen liegen somit um zwei bis drei Grössenordnungen (100-1000) über entsprechenden Dimensionen der Leiterbahndicken und Leiterbahnenabstände in intergrierten Schaltkreisen (ICs). Zwischen Leiterplatten und ICs besteht sehr grosse Dimensionskluft.

Der Grund für die noch heute übliche, man möchte fast sagen, archaische Bauweise von Leiterplatten ist wohl darin zu sehen, dass es bisher nicht nötig war, wesentliche Neuerungen in der Leiterplattentechnik bezüglich der Abwärts-Dimensionierung durchzuführen. Die heute übliche Bauweise ist auch technisch bedingt. Um Bauelemente tragen zu können, müssen die Leiterplatten eine gewisse Festigkeit aufweisen, wovon man bisher auch nicht abgekommen ist. Dies führt direkt zu Sachzwängen. Dem mechanischen Durchbohren zur Herstellung von Durchplattierungen bspw. sind mit den heute kleinsten Bohrdurchmessern von 0,2mm Grenzen gesetzt, Grösse und Lagegenauigkeit galvanisch durchplattierter Löcher sind ebenfalls limitiert.

Dieses sozusagen Stagnieren der traditionellen Herstellungstechnik von Leiterplatten, bei gleichzeitig rasanter Entwicklung der integrierten Bauelemente führt unausweichbar zu den oben erwähnten Strukturproblemen. Komplexe Chips führen zu immer komplizierteren Vernetzungen auf der Leiterplatte. Die Dimensionen der Strompfade, der Löcher und Durchplattierungen sind aber seit einiger Zeit praktisch unverändert geblieben. Dies hat die Folge, dass man bei heutigen Anwendungen bis zu 60-lagige Leiterplatten verwendet, deren Layouterstellung einen hohen Aufwand verursacht und deren Herstellung immer kostspieliger wird. Die Miniaturisierung kompletter Schaltungen wird durch den Zielkonflikt der Chips, die vorzu dichter integriert werden und den Leiterplatten, die an die Layout-Miniaturisierungsgrenze stossen und den Anforderungen nicht mehr folgen können, überproportional verschärft. Ein Ausweg über die Erhöhung der Lagenzahl für Multi-Chip-Module (MCM) in Leiterplatten in Folge der Verdichtung der Chips, führt zu ebensolchen überproportionalen Herstellungskostensteigerungen, verglichen mit den Herstellungskosten der Chips selbst, den eigentlichen Herzstücken der gesamten Schaltung.

Auch ist die Miniaturisierung nicht mehr nur auf kleinste Dimensionen von Leiterbahnenabstände in integrierten Schaltungen beschränkt, sondern sie gilt auch für die elektrischen und elektronischen Geräte selbst. Kleine Taschen-Fernseher, tragbare Personal-Computer (Laptop), Handkameras und andere hochkomplexe Geräte bedingen notwendigerweise auch klein dimensionierte Leiterplatten und Leiterfolien. Oft ist es notwendig, die Form und Gestaltung von Leiterplatten den Geräten anzupassen, hierfür eignen sich insbesonders flexible Leiterfolien.

Folien können von Rolle zu Rolle verarbeitet werden, was einen hohen Automatisierungsgrad ermöglicht. Ausserdem sind die bei herkömmlichen Materialien verwendeten Durchlaufanlagen für zum Beispiel Entwickeln des Fotobildes, Aetzen, Strippen, Bürsten etc. immer mit einem Transportsystem (Fliessband, Klammern), das die starren Platten durch die Maschine transportiert. Bei einer Folie kann auf ein derartiges Transportsystem verzichtet werden, was nicht nur anlageseitige Einsparungen mit sich bringt, sondern auch das Transportsystem eliminiert, das oftmals Defekte am Produkt erzeugt, wie Kratzer, Druckstellen und so weiter.

Ferner generieren die Folien keinen Staub; dies ist ein weiterer wesentlicher Vorteil. Bei starren Materialien, die in Form von Nutzen verarbeitet werden. wird von den Schnittkanten Staub freigesetzt, der in der Folge zu einer reduzierten Ausbeute führt. Die Folienoberfläche kann auch, dank ihrer Ebenheit und glatten Oberfläche sehr einfach gereinigt werden. Im aufgerollten Zustand ist die Oberfläche des Folienmaterials auch von allen Kontaminationen, insbesondere Staub, geschützt.

Eine Folie wird im Unterschied zum herkömmlichen Material in einem kontinuierlichen Prozess hergestellt, das heisst, das Material zeigt konstante Parameterwerte entlang der Folienbahn. Insbesondere das Schrumpf- und/oder Elongationsverhalten ist konstant und kann daher einfach kompensiert werden. Die Folienoberfläche ist im Gegensatz zu starrem, glasfasergewebeverstärktem Material sehr eben bzw. glatt und nicht durch das Glasfasergewebe sozusagen oberflächenmoduliert. Dies ermöglicht bei der photochemischen Uebertragung von Bildern, insbesonder beim Belichten, eine bessere Ausbeute. Und da die Folie ausserdem flexibel ist, kann sie sich leicht an die Photomaske, die auch ein Film ist, anschmiegen, wodurch sogenannte Hohlbelichtungen vermieden werden. Dies führt natürlich auch zu einer besseren Ausbeute.

Durch den Einsatz einer Folie können sowohl starre als auch flexible Anwendungen abgedeckt werden. Ausserdem sind starr-flexible Kombinationen möglich. Bei der Verwendung einer dünnen Folie, sind die entstehenden Lochdurchmesser im Verhältnis zur Lochlänge (Lochtiefe) sehr gross, wenn man dieses Verhältnis mit üblichen Leiterplatten vergleicht. Eine 25 µm dicke Folie mit einem relativ feinen Loch von nur 80 µm hat ein Verhältnis von mehr als 1:3. Dies ist beim elektrogalvanischen Durchkontaktieren von grossem Vorteil, da der Materialaustausch vom Loch zum umgebenden Elektrolyt wesentlich besser funktioniert als in dünnen, langen Löchern herkömmlicher Art in Leiterplatten, die bekanntlich sehr schwierig galvanisch durchzukontaktieren sind.

Eine dünne Folie bereitet bezüglich der in Z-Richtung auftretenden thermischen Expansion keinerlei Probleme. Herkömmliche Leiterplatten mit 1 bis 5 mm Dicke, zeigen in Z-Richtung eine nicht zu unterschätzende thermische Ausdehnung, die dazu führen kann, dass die in den Löchern eingebrachte galvanische Schicht reisst, was einen elektrischen Defekt darstellt.

Bei elektronischen Schaltungen hoher Packungsdichte ist üblicherweise auch die Wärmeableitung ein sehr grosses Problem. In herkömmlichen Leiterplatten werden daher sogenannte Heat Sinks einlaminiert oder auf die Oberfläche auflaminiert. Diese bestehen aus thermisch gut leitfähigen Materialien wie Kupfer oder Aluminium und haben die Aufgabe, die von den Komponenten erzeugte Wärmeenergie möglichst effizient an die kühlen Stellen wie bspw. die Gehäusewand weiterzuleiten. Da in der konventionellen Technik die Leiterplatte meist 1 - 5 mm dick ist, bedeutet dies, dass die von den Komponenten generierte Wärmeenergie zuerst durch die Leiterplatte hindurch zur Kühlplatte geleitet werden muss. Da die Leiterplatte primär aus einem schlechten Wärmeleiter (Kunststoff, Glas) besteht, ergibt sich dadurch ein hoher thermischer Widerstand zwischen dem wärmeerzeugenden Baustein und der Kühlplatte. In vielen Fällen müssen daher spezielle, nur für den Zweck der Wärmeleitung vorgesehene Durchkontaktierungen (thermal vias) vorgesehen werden, die aber sehr viel kostbaren Platz beanspruchen. Dies führt in vielen Fällen dazu, dass weitere Leiterlagen nötig werden, die die Dicke der Leiterplatte nochmals steigern.

Bei Verwendung von dünnen Folien wird selbst bei extremsten Packungs- und Verbindungsdichten (Leiterbahnen) die Leiterplatte nur etwa 0,1 - 0,2 mm dick. Diese Folie stellt daher einen vergleichsweisen geringen Wärmewiderstand dar und verbessert dadurch das thermische Management wesentlich.

Werden zum Aufbau der elektronischen Schaltung sogenannte Leedless Ceramic Chip Charriers (LCCC) bzw. grössere keramische Kondensatoren und andere Bauteile aus einem Material mit kleinen thermischen Ausdehnungskoeffizienten verwendet und diese ohne elastische Verbindung zum Substrat (das wären bspw. elastische Kontaktbeinchen) direkt auf die Leiterplatte gelötet, so muss zur Erzielung einer hinreichend hohen Zuverlässigkeit der Lötstellen die Leiterplatte in ihrem thermischen Ausdehnungsverhalten angepasst werden. Ueblicherweise werden dabei gewalzte Metallfolien aus Kupfer-Invar-Kupfer (CIC) oder Kupfer-Molybdän-Kupfer (CMC) mit einem Ausdehnungskoeffizienten von ca. 4 - 6 ppm/°K verwendet. Des weiteren sind Anwendungen mit Kohlenstoffaser-Verbundwerkstoffen bzw. Aramidfaser-Verbundwerkstoffen bekannt.

In der konventionellen Technik haben die unverstärkten Leiterplatten immer im Bereich von 16-18 ppm/°K und müssen, da die Platten üblicherweise zwischen 1-5 mm dick sind, durch sehr viel CIC bzw. CMC etc. stabilisiert werden. Dies führt zu einer weiteren Zunahme der Gesamtdicke der Leiterplatten, was nicht nur die Zuverlässigkeit negativ beeinflusst, sondern auch das thermische Management erschwert. Zudem werden solche Leiterplatten relativ schwer, was insbesondere in der Avionik nicht erwünscht ist.

Werden dagegen Folien als Basismaterial verwendet, so liegt die Gesamtdicke einer komplexen Leiterplatte bei ca. 0,1 bis 0,2 mm. Wird diese Folienleiterplatte auf einen Träger auflaminiert, der einen niedrigen thermischen Ausdehnungskoeffizienten aufweist, so ist der Ausdehnungskoeffizient der Leiterplattenoberfläche fast identisch mit dem der Supportplatte, da die dünne Folie keinen grossen Einfluss auf die Gesamtstruktur ausübt. Zudem ist die Folie nicht durch Glasfasern verstärkt, das heisst, der Elastizitätsmodul der Folie ist wesentlich niedriger als der Elastizitätsmodul glasfaserverstärkter Materialien und demnach wird die stabilisierende Wirkung der Supportplatte nicht negativ beeinflusst.

Werden innerhalb einer elektronischen Schaltung hochfrequente Signale verwendet, so spielt die sogenannte Impedanz (das ist der Wellenwiderstand) der elektrischen Leitungen eine wesentliche Rolle. So werden zur Vermeidung von Reflexionen Leitungen mit 50 Ω Impedanz (Standard) oder höher gefordert. Neben der absoluten Grösse des Wellenwiderstandes ist auch die Konstanz über die Leiterlänge für die Hochfrequenzeigenschaften sehr wichtig. Dabei spielt die Dickenkonstanz des Dielektrikums eine wichtig Rolle. Die Verwendung einer Folie gibt gegenüber herkömmlichen Basismaterialien wesentlich bessere Toleranzen bezüglich der Dielektrikumskonstante und Materialdicke.

Die vorliegende Erfindung hat zur Aufgabe, eine optimale und dichteste Strompfadbelegung auf Leiterplatten zu erzielen. Sie soll einen Weg zeigen, auf welchem Leiterplatten ohne wesentliche Kostensteigerung mit erheblich erhöhter Funktionsdichte (dem Zusammenwirken von Bauelementen und deren Verbindungen, erhöhter Verdrahtungsdichte, etc) auch für Leiterplatten mit hochkomplexen Funktionen hergestellt werden können. Es sollen dabei bekannte und bewährte Techniken, Materialien und dergleichen zur Anwendung kommen, bspw. zur Herstellung der Leiterstrukturen sollen bekannte nasschemische Verfahren anwendbar sein. Diese Leiterplatten sollen eine gegenüber bekannten Leiterplatten um eine Grössenordnung oder darüber erhöhte Funktionsdichte aufweisen und trotzdem sollen sie in bezug auf die Weiterverarbeitung, insbesonders bezüglich der Bestückung und der Anwendung mit bekannten Systemen kompatibel sein. Ferner soll die Herstellung von Leiterplatten unter Verwendung solcher Halbzeuge automatisch, bspw. von-Rolle-zu-Rolle ablaufbar sein, wobei auch ein zuführender Chargenbetrieb durch Einschleusung von bspw. Trägerplatten möglich sein soll.

Diese Aufgabe wird durch die in den Patentansprüchen definierte Erfindung gelöst.

Die erfindungsgemässe Idee besteht in einem ersten Ansatz darin, die Anforderung an die mechanische Festigkeit von der bis anhin damit verbundenen Anforderung der Schaltungsverbindung funktionsmässig zu trennen, um die reine Schaltungsverbindung, insbesondere für Signale, "näher" an die elektrisch-technischen Eigenschaften der Chips bringen zu können. Um dies zu realisieren wird die Layout-Miniaturisierung ohne Rücksicht auf die mechanische Festigkeit des Substrates optimiert. Auch die elektrische Stromversorgung kann funktional abgetrennt und separat optimiert werden. Anders als bei der üblichen Entwicklung integrierter Schaltungen strebt die vorliegende Erfindung somit eine Verkleinerung sämtlicher Dimensionen der Leiterplatten an, in dem die einzelnen Funktionen (Signalführung, Speisung, mechanische Festigkeit) funktionell getrennt miniaturisiert werden, um sie in finalisierenden Verfahrensschritten zu einer hochverdichteten Leiterplatte zu "synthetisieren". Die rigorose Miniaturisierung des signalführenden Layouts gelingt über ein rein chemisches Vorgehen unter Vermeidung mechanischer Mitteln. Mit Molekülen und Atomen kann man feinere Durchplattierungen "bohren" und erst noch alle simultan. Auf diese Weise kann der Zielkonflikt zwischen den integrierten Schaltungen und den Leiterplatten mittels eines Dimensionierungssprunges überwunden werden. Durch die sehr markante Herabminderung der Dicke und damit der Steifigkeit einer Leiterplatte ist der Aufbau einer solchen einer Rolle-zu-Rolle-Fertigung zugänglich. Bei einer Dickenzunahme, bei der die Radienänderung durch Biegen beim Rollen kritisch werden könnte, wird eine Faltung des aus Leiterplatten bestehenden Bandes an bestimmten Sollbruchstellen vorgenommen. Ein solcher Faltstapel als Prozesspuffer kann in jegliche weiter "Rollenverarbeitung" einbezogen werden und bietet ausserdem die Möglichkeit für einen partiellen Chargenbetrieb, bspw. zum Einführen eines Substrates, Stabilisierungselementes und so fort.

Das erfindungsgemässe Verfahren beruht im wesentlichen darauf, dass an Stelle einer Leiterplatte in Abtrennung aller Funktionen, die nichts mit dem Layout zu tun haben, in einem vorgängigen Verfahrensschritt ein zu einer Leiterplatte aufbaubares Halbzeug hergestellt wird, welches es ermöglicht, eine drastische Verkleinerung der Funktionseinheiten auf Leiterplatten und eine ebensolche Erhöhung ihrer Funktionsdichte zu erzielen. Das erfindungsgemässe Halbzeug besteht aus einer extrem dünnen Folie mit extrem kleinen Löchern. Die Lochdurchmesser können um fast eine Grössenordnung (bis zu 20µm) verkleinert werden, was bspw. eine klare Sub-100µm-Technik ermöglicht. Ein solches Halbzeug dient als steifer mechanischer Träger, es ist nur zur Signalführung vorgesehen, welche Leiterbahnen in einem späteren Herstellungsschritt gemäss vorgegebenem Layout realisiert werden. Auch Leiterbahnen für die elektrische Speisung werden vorteilhafterweise nicht auf einem solchen Halbzeug angesiedelt. Die Wirkung der Miniaturisierung äussert sich vor allen Dingen im Durchmesser für die Durchplattierungslöcher; eine Erniedrigung der Lochdurchmesser geht quadratisch mit der Dichte der Strompfadbelegung ein. Solche Leiterplatten ermöglichen durch ihren bezüglich der Impedanz günstigen Aufbau auch die Übertragung hochfrequenter Signale (mit Frequenzen > 1GHz). Schon mit zwei- bis dreimal kleineren Lochdurchmessern benötigt man lediglich drei- bis vierlagige Multilaver um dieselbe Schaltungskomplexität wie heute mit 20- oder 25- lagigen Leiterplatten zu erreichen.

Im folgenden wird anhand einiger Ausführungsformen ein erfindungsgemässes Vorgehen diskutiert. Die nachfolgend aufgeführten Figuren zeigen im Detail, wie man am besten vorgeht.
- Fig. 1: zeigt ein Diagramm, in dem die Verbindungsdichte verschiedener Substrattechnologien gegenüber der damit einhergehenden Flächenkosten gezeigt werden.
- Fig. 2: zeigt in einem vergrösserten Ausschnitt eine beispielhafte Ausführungsform von Strompfaden und Durchplattierungen eines Teils einer Leiterplatte.
- Fig. 3: zeigt im Vergleich die Leiterdichte zweier traditioneller Layouts, Strompfade und Durchplattierungen in DIL- und SMD-Technik gegenüber der markant erhöhten Leiterdichte einer beispielhaften Ausführungsform von Strompfaden und Durchplattierungen von Leiterplatten, hergestellt aus Halbzeugen nach dem erfindungsgemässen Verfahren.
- Fig. 4: zeigt in vergrösserter Darstellung Strompfade und vorbereitete Lötflächen, wobei die vorbereiteten Lötflächen plasma-geätzte Durchplattierungen aufweisen.
- Fig. 5: zeigt in vergrösserter Darstellung eine beispielhafte Ausführungsform zweier Lagen von Strompfaden eines MCMs aus Halbzeugen gemäss Erfindung hergestellt.
- Fig. 6: zeigt die einzelnen Schritte (6a-6e) der Herstellung eines Halbzeuges nach dem erfindungsgemässen Verfahren, das in weiteren Schritten zu einem MCM (bspw. gemäss Figur 5) gefertigt wird.
- Fig. 7: zeigt eine beispielhafte Ausführungsform eines Teils einer Leiterplatte hergestellt aus einem Halbzeug nach dem erfindungsgemässen Verfahren, welche mit einem mechanischen Träger verbunden ist.
- Fig. 8: zeigt eine beispielhafte Ausführungsform eines fertig bestückten MCM, das aus Halbzeugen nach dem erfindungsgemässen Verfahren hergestellt wurde.
- Fig. 9a bis 9d: zeigen schematisch und teilweise im Schnitt die Anordnung von präkonditionierten Durchplattierungen.
- Fig. 10: zeigt schematisch ein Verfahren zur Herstellung von Durchplattierungen in Folienmaterial auf Bandanlagen, welches Folienmaterial als Endlos-Universalsubstrat schliesslich aufgerollt und zur Weiterverarbeitung bereit gehalten wird.
- Fig. 11 bis 16: zeigen die verschiedenen Stufen für die Herstellung einer Vierlagenleiterplatte, darin wird auch das Prinzip erkennbar für den Aufbau von Leiterplatten mit eine Vielzahl von Lagen.
- Fig. 17 und 18: zeigen Beispiele einer unterstützenden Massnahme bei der Verarbeitung auf Bandanlagen wie bspw. gemäss Figur 10.

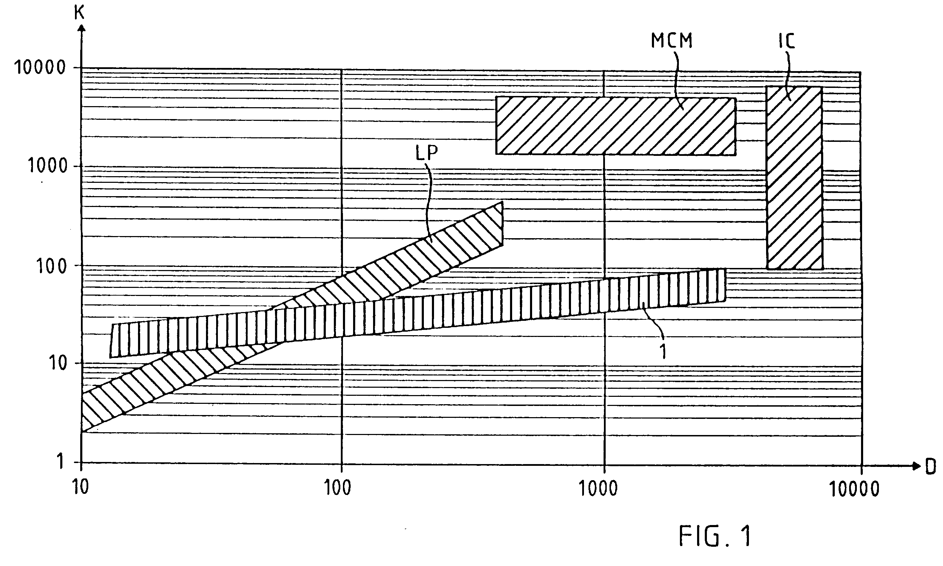

**Figur 1** zeigt ein anschauliches Diagramm der Verbindungsdichte verschiedener Substrattechnologien gegenüber den damit einhergehenden Flächenkosten. Es wird der Kostenanstieg von MCMs in üblicher Leiterplattentechnik; mit solchen gemäss Erfindung verglichen werden, die aus nachfolgend zu diskutierenden Halbzeugen hergestellt werden. Auf der Abszisse ist die Verbindungsdichte D (der Anzahl Verbindungen pro Einheitsfläche) in beliebigen Einheiten aufgetragen. In Funktion dieser Dichte D gibt die Ordinate die ungefähren relativen Kosten K der Herstellung einer Leiterplatte pro Flächeneinheit wieder. Der linke Bereich LP kennzeichnet die Dichte D gemäss der kostengünstigen und wenig verdichteten konventioneller Printed Circuit Boards- oder PCB-Technik, der rechte Bereich IC kennzeichnet die Dichte D hochverdichteter Schaltkreise, wie sie heute gebraucht werden. Der obere Bereich MCM kennzeichnet die mit wachsender Verdichtung teueren in Keramik-Mehrlagentechnik oder Dünnschicht-Mehrlagenstrukturen hergestellten MCMs. Der untere Bereich 1 kennzeichnet die mit wachsender Verdichtung geringfügig ansteigenden Kosten für Leiterplatten aus Halbzeugen gemäss dem vorliegenden erfindungsgemässen Verfahren für MCMs. Die Produkte aus dem erfindungsgemässen Verfahren sind unter dem Namen DYCOstrate^{(R)} im Markt eingeführt worden. Aus der Darstellung von Figur 1 können drei Aussagen getroffen werden. Erstens weist die Herstellung klassischer Leiterplatten einen sehr starken Preisanstieg mit der Verdichtung auf, ohne jedoch den gewünschten Bereich IC hochverdichteter Schaltkreise zu erreichen (siehe Bereich LP). Zweitens weisen die in Keramik-Mehrlagentechnik oder Dünnschicht-Mehrlagenstrukturen hergestellten MCMs eine natürliche Miniaturisierungsgrenze auf, derart, dass auch sie den Verdichtungsbereich IC trotz hohem Aufwand nicht erreicht (siehe Bereich MCM). Drittens werden gerade diese beiden Nachteile der bisherigen MCM-Technik (hohe Kosten und Begrenztheit) durch das erfindungsgemässe Verfahren überwunden (siehe Bereich 1). Verglichen mit der üblichen Technik sind komplexe (MCM) Leiterplatten, hergestellt aus Halbzeugen nach dem erfindungsgemässen Verfahren sehr wohl in der Lage, wesentlich näher an den Verdichtungsbereich IC zu kommen.

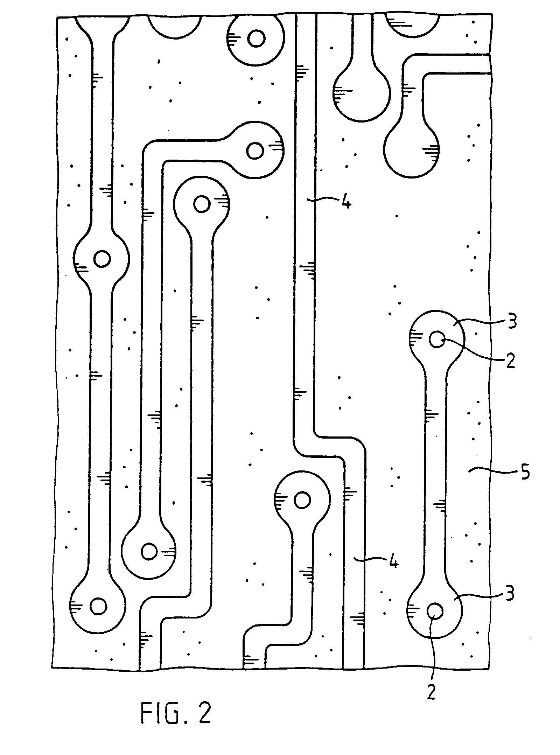

**Figur 2** zeigt eine beispielhafte Ausführungsform einer Signalleitungsschicht in einem MCM in über 40-facher Vergrösserung. Die Strompfade 4 sind 75 µm, die Durchplattierungslöcher 2 sind 100 µm (verzinnt entsprechend kleiner), die Lötaugen 3 sind hier 200 µm im Durchmesser, soviel, wie das kleinste konventionell gebohrte Loch, und die Dichte der Durchplattierungen ist höher also 10'000 pro dm². Die Dicke der Leiterfolie beträgt 25 bis 50 µm. Das Halbzeug, aus dem solche Folien hergestellt werden, weist nur die Durchplattierungslöcher 2 auf, deren Herstellung weiter unten diskutiert wird. Diese hier gezeigten Dimensionen können ohne grosse technische Probleme noch weiter verkleinert werden.

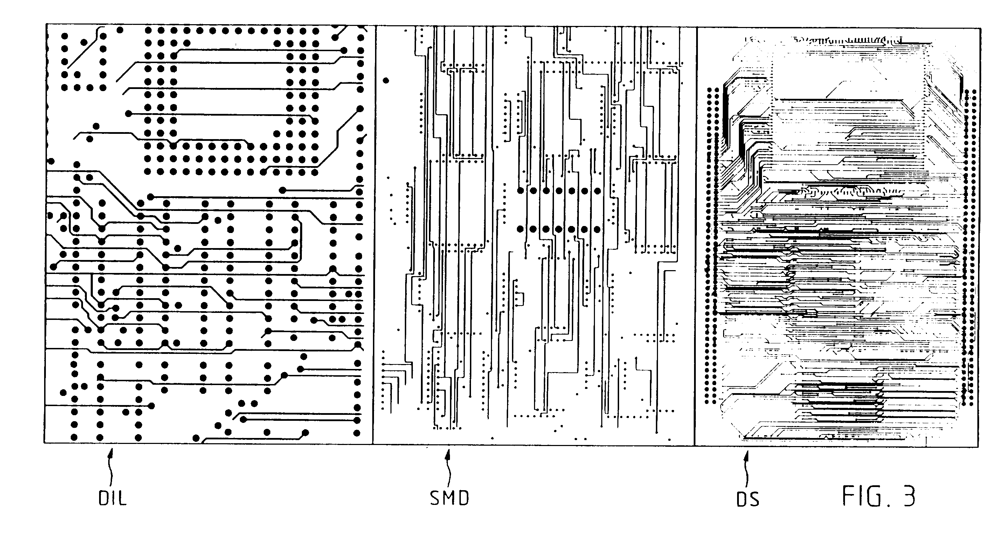

In **Figur 3** sind illustrativ zwei beispielhafte Ausführungsformen traditioneller Leiterplattentechnik im Vergleich zur Herstellung von Leitplatten mit erfindungsgmässem Halbzeug zu sehen. Es handelt sich um Ausschnitte von nichtbestückten Leiterplatten. Auf der linken Seite ist eine nach der Dual Inline- oder DIL-Technik konstruierte Leiterplatte abgebildet, in der Mitte ist eine nach der SMD-Technik konstruierte Leiterplatte abgebildet, auf der rechten Seite ist eine Leiterplatte DS aus Halbzeugen nach dem erfindungsgemässen Verfahren abgebildet (DS steht für DYCOstrate^{(R)}). Diese drei Ausschnitte von Leiterplatten sind im Massstab 1:1 abgebildet. Figur 3 zeigt anschaulich, dass die Reduzierung der Durchmesser der Durchplattierungen zu einer quadratisch wachsenden Verdichtung der strukturierten Schaltung führt.

In der gezeigten Leiterplatte nach der DIL-Technik werden kreisrunde metallische Plattierungsformen verwendet. Auf dem elektrisch isolierenden Träger liegen nach bekannten photochemischen Verfahren gedruckte Strompfade vor. Durchplattierungen verbinden die Strompfade je einer Seite einer Leiterplatte miteinander. Die Dimensionen der Strompfade und der Durchplattierungen liegen im Millimeterbereich. Bemerkenswert ist, dass der Durchmesser der Plattierungen um einen Faktor 5 grösser ist als die Breite der Strompfade.

In der gezeigten Leiterplatte nach der SMD-Technik werden mechanisch oder galvanisch erzeugte Durchplattierungen und nach bekannten und gängigen photochemischen Verfahren gedruckte elektrische Strompfade verwendet. Die kreisrunden, doch schon kleineren Durchplattierungen verbinden zwei Ebenen der Leiterplatte, beispielsweise deren Vorder- und Rückseite miteinander. Sie dienen auch zur Bestückung mit einfachen elektronischen Bauelementen. Die elektrische Kontaktierung und mechanische Befestigung solcher einfacher Bauelemente erfolgt über Lötflächen (nicht sichtbar, da diese Abbildung eine Signalebene zeigt, die keine Lötflächen beinhaltet). Verglichen mit den Durchplattierungen der DIL-Technik sind die Durchplattierungen der SMD-Technik, inklusive der Lötflächen und der Lötaugen, etwa um eine Faktor 3 kleiner. Auch die gedruckten Strompfade sind schmaler dimensioniert. Als Folge davon hat die Anzahl der Strompfade verglichen mit der Anzahl der Durchplattierungen zugenommen. Man kann sagen, dass die Dimensionen der Strompfade und der Durchplattierungen im Halb-Millimeterbereich liegen, sie betragen respektive 0,3 bis 0,7mm. Der Durchmesser der Durchplattierungen ist ca. um einen Faktor 3 grösser als die Breite der gedruckten Strompfade.

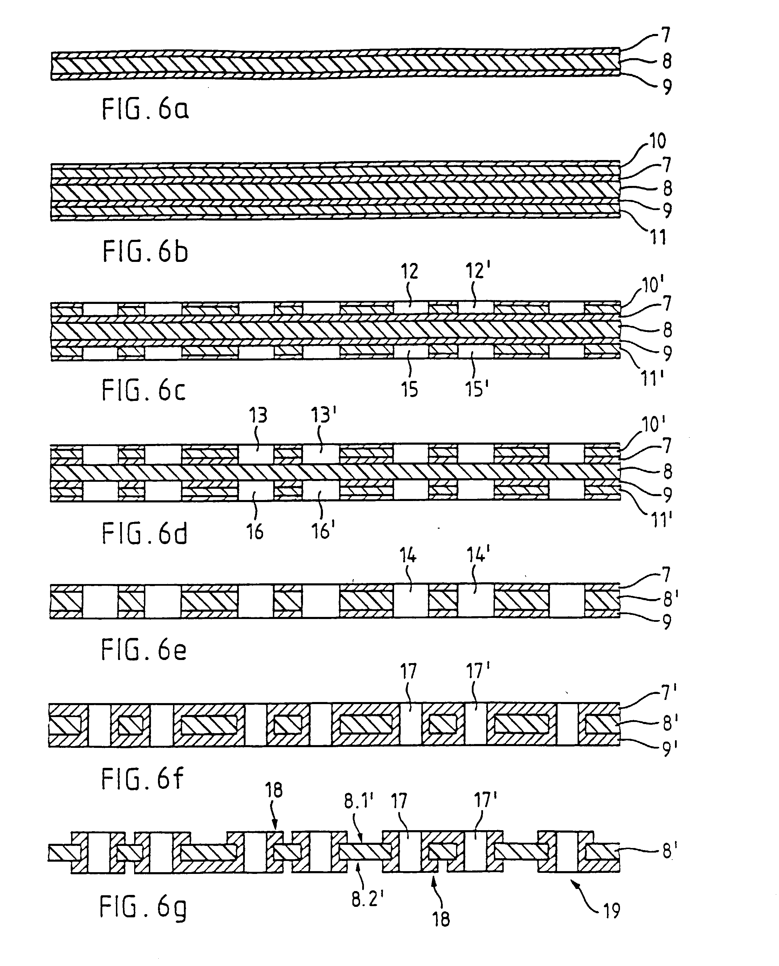

Die aus Halbzeugen nach dem erfindungsgemässen Verfahren hergstellten Leiterplatten DS, weisen nach einem bekannten und bewährten Plasma-Ätz-Verfahren erzeugte Durchplattierungen und nach photochemischen Verfahren strukturierte Strompfade auf. Die Strompfade sind gegeneinander durch eine dünne Nichtmetallfolie elektrisch isoliert. Auffallend ist die drastische Steigerung der Anzahl gedruckter Strompfade. Erst auf den zweiten Blick nimmt man die Durchplattierungen wahr. Diese Verdichtung des Layouts ist eine direkte Folge der im erfindungsgemässen Verfahren vorgenommenen Reduzierung des Durchmessers der Durchplattierungen. Diese Verdichtung ist der erste erwünschte Effekt des erfindungsgemässen Verfahrens. Die plasma-geätzten Löcher haben Durchmesser deutlich kleiner als 100µm. Sie können an 20µm heranreichen. Die Breite der Strompfade liegt in der gleichen Grössenordnung. Dieses Verfahren zur Herstellung solcher Halbzeuge wird weiter unten in der Beschreibung gemäss Figuren 6a bis 6g im Detail beschrieben. Verglichen mit den Durchplattierungen der DIL-Technik und den Durchplattierungen der SMD-Technik sind die als Durchplattierungen verwendeten plasma-geätzten Löcher nach dem vorliegenden erfindungsgemässen Verfahren somit um einen Faktor 30 respektive 10 kleiner. Die Durchmesser der Durchplattierungen sind nicht mehr um einen Faktor 5 grösser als die Breite der Strompfade, wie bei den DIL- und SMD-Techniken, dieser Faktor ist kleiner, beispielsweise 3, 2 oder auch 1 (gleich gross). Aus dieser Reduzierung der Durchmessers der Durchplattierungen folgt zum einen, dass pro Einheitsfläche der verwendeten Leiterplatte mehr Durchplattierungen und Strompfade angebracht werden können (Verdichtung oder erster erwünschter Effekt), zum anderen folgt, dass prinzipiell mehr Platz für Strompfade vorhanden ist. Dieser "zusätzliche" Platz für Strompfade wird zur Ansteuerung, Versorgung und Kontaktierung der grossen Anzahl von Ein- und Ausgängen hochkomplexer Bauelemente dringend benötigt, dies ist der zweite erwünschte Effekt des erfindungsgemässen Verfahrens. Dies wird an der im Ausschnitt der Leiterplatte DS in Figur 3 festzustellenden Zunahme der Anzahl der Strompfade relativ zur Anzahl der Durchplattierungen (verglichen mit den DIL- und SMD-Techniken) offensichtlich. Der "zusätzliche" Platz erlaubt einen vollständig anderen Aufbau von Leiterplatten. Durch diese nun ermöglichte Verlagerung der Strompfade in die einzelnen Ebenen einer (in der Regel mehrlagigen) Leiterplatte erzielt man einen dritten erwünschten Effekt, nämlich dass die Anzahl der Ebenen solcher erfindungsgemässen Leiterplatten drastisch reduziert wird, von beispielsweise 25 auf drei oder vier. Dies wird weiter unten in der Beschreibung gemäss Figur 6 im Detail beschrieben.

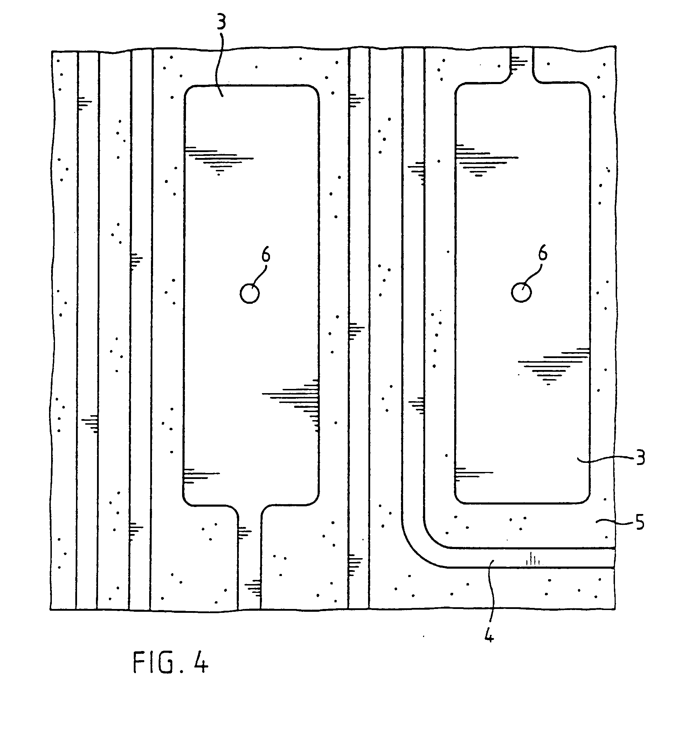

**Figur 4** zeigt eine beispielhafte Ausführungsform von vorbereiteten Lötflächen von Leiterplatten, die auch dazu benützt werden, um plasma-geätzte Durchplattierungen einzubringen. Es handelt sich um einen Ausschnitt einer noch nicht bestückten Leiterplatte. Der Ausschnitt ist mit rund 35-facher Vergrösserung abgebildet. Die plasma-geätzten Durchplattierungen sind hier kreisrunde Löcher 6, welche mitten in, hier rechteckige, vorbereitete Lötflächen 3 für bspw. Anschlüsse eingebracht wurden. Diese Kreisform der Mündungen der plasma-geätzten Löcher ist natürlich nicht zwingend, es lassen sich auch Löcher mit anderen regelmässigen oder unregelmässigen Formen herstellen. Die Durchplattierungen sind über Strompfade 4 miteinander verbunden. Die Strompfade 4 sind auf einem elektrisch isolierenden Träger 5 gedruckt und durch diesen gegeneinander elektrisch isoliert. Figur 4 zeigt ausserdem, dass plasma-geätzte Löcher um mindestens eine Grössenordnung kleiner sind als traditionell mittels mechanischen Aufbohrens oder mittels Nasschemie galvanisch erzeugte Löcher. Sie zeigt ferner, dass sich solch kleine Löcher, die deutlich kleiner als 100µm sind, nötigenfalls direkt in Leiterbahnen eingebracht werden können. In diesem Beispiel ist die Durchplattierung rund 30-mal kleiner als die vorbereitete Lötfläche. Eine solch grosse vorbereitete Lötfläche wird für makroskopisches Löten mit dementsprechend grossen Lötaugen benutzt (siehe Beschreibung zu Figur 2).

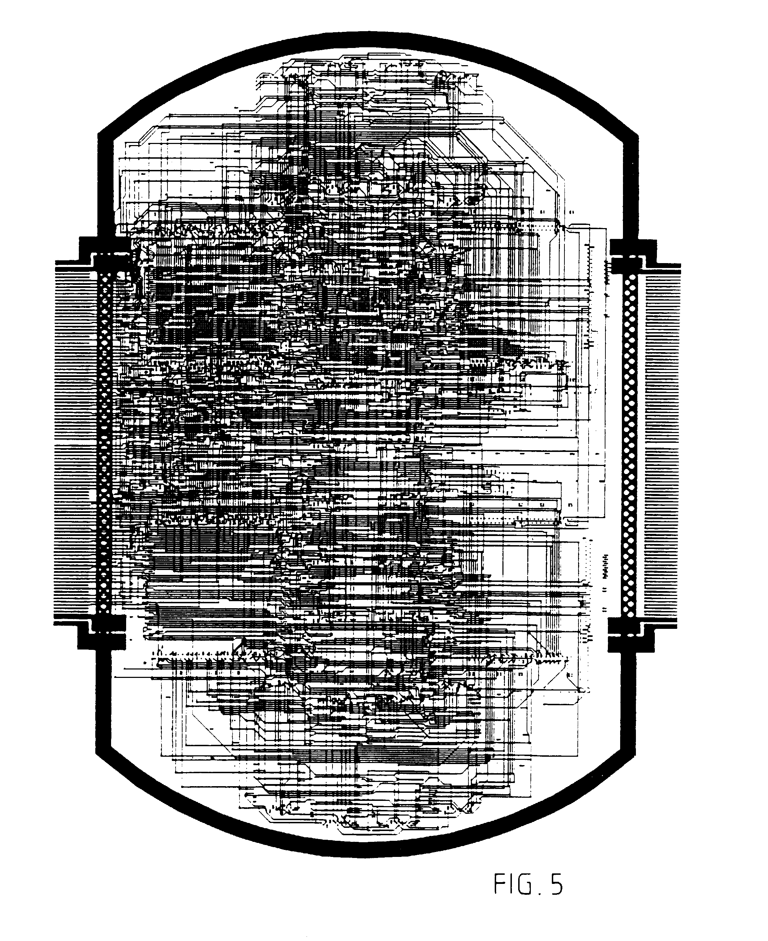

**Figur 5** zeigt eine weitere, sehr eindrückliche Realisierung der Sub-100µm-Technik für Leiterplatten, wie sie mit Halbzeugen gemäss Erfindung möglich ist. Es handelt sich um einen rund zweimal vergrösserten Ausschnitt. Man sieht, dass alleine die Überlagerung von zwei Layout-Lagen schon ein sehr dichtes Muster erzeugt (verdichtetes Verdrahtungsbild). Bei mehr Lagen ist es entsprechend komplizierter. Die Figur 5 zeigt auf, dass die aus dem erfindungsgemässen Verfahren resultierende Reduzierung der Lagenzahl der Leiterplatten nicht nur zu Materialeinsparungen (weniger Lagen ist gleichbedeutend mit weniger Material), sondern auch zu einer bedeutenden Verringerung des Arbeitsaufwands führt, denn dieser ist bedeutend, wenn es darum geht, Leiterplatten mit vielen Lagen zu entwerfen.

In **Figur 6** sind die einzelnen Schritte 6a bis 6e der Herstellung einer beispielsweisen Ausführungsform eines Halbzeugs nach dem erfindungsgemässen Verfahren zu sehen. Die Darstellung ist zur Veranschaulichung des Verfahrens stark schematisiert. Als Ätzverfahren können bekannte nasschemische Verfahren oder bekannte Plasma-Ätz-Verfahren verwendet werden. Ebenso sind Kombinationen dieser genannten Verfahren möglich. Bei allen Ätzverfahren muss im allgemeinen dafür gesorgt werden, dass diejenigen Teile, die nicht weggeätzt werden sollen, durch eine Photresistschicht geschützt sind.

In Figur 6a sieht man im Schnitt eine zweilagigen Leiterfolie, bestehend aus einer ersten Metallschicht 7, beispielsweise aus Kupfer, sowie einer zweiten Metallschicht 9, ebenfalls beispielsweise aus Kupfer, und schliesslich einer intermediären Nichtmetallschicht 8, beispielsweise aus Polyimid oder aus Epoxydharz. Die Dicke dieser dreischichtigen Folie beträgt typischerweise 50 bis 120µm, sie kann natürlich auch dünner sein. Eine solche dreischichtige Folie ist das Ausgangsmaterial für die im erfindungsgemässen Verfahren herzustellenden Halbzeuge zur Verwendung für mehrlagige Leiterplatten mit Durchplattierungen. Diese dreischichtige Folie kann starr oder flexibel sein.

In Figur 6b werden die beiden Metallschichten 7, 9 mit Photoresist 10, 11 beschichtet. Vor diesem Beschichtungsvorgang des Photoresists wird die Leiterfolie gewöhnlicherweise durch chemisches Ätzen oder Jet-Scrubbing gereinigt. Es kann handelsübliches, trockenes oder flüssiges Photoresist aufgetragen werden. Die Schicht Photoresist 10 bedeckt die Metallschicht 7, die Schicht Photoresist 11 bedeckt die Metallschicht 9.

In Figur 6c erfolgt in einem bekannten und bewährten photochemischen Verfahren die Strukturierung der Durchplattierungen. Gemäss einer Photomaske werden die Schichten Photoresist 10, 11 belichtet und Anlagen für die Öffnungen 12, 12', 15, 15' erzeugt. Diese Öffnungen 12, 12', 15, 15' stellen vorgearbeitete Durchplattierungen dar. Sie reichen von der äusseren Oberfläche der photoresistbeschichteten Leiterfolie aus gesehen bis auf die Metallschichten 7, 9 hinab. Die mit solchen Löchern 12, 12', 15, 15' versehenen Photoresistschichten werden als Schichten Photoresist 10', 11' bezeichnet. Typischerweise haben dies Öffnungen Durchmesser von weniger als 100 µm, sie sind also sehr klein.

In Figur 6d werden die Metallschichten 7, 9 im Bereich der Öffnungen 12, 12', 15, 15' nasschemisch durchgeätzt. Die aus diesem ebenfalls bekannten und bewährten Verfahrensschritt resultierenden Öffnungen 13, 13', 16, 16' reichen von der äusseren Oberfläche der photoresistbeschichteten Leiterfolie aus gesehen bis auf die intermediäre Nichtmetallschicht 8 hinab. Auch diese bis auf die Nichtmetallschicht 8 hinabreichenden Öffnungen 13, 13', 16, 16' sind lediglich vorgearbeitete Durchplattierungen. Nach diesem Verfahrensschritt liegt das Dielektrikum frei.

In Figur 6e werden die Schichten Photoresist 10', 11' durch nasschemisches Strippen entfernt. Im gleichen Ätzvorgang wird im Bereich der Öffnungen 13, 13', 16, 16' die intermediäre Nichtmetallschicht 8 durch Plasma-Ätzen abgetragen. Die derart "plasmagebohrte" Nichtmetallschicht wird mit 8' bezeichnet. Durch diesen Verfahrensschritt entstehen kleine Durchgangslöcher 14, 14', durch welche später die beiden Metallschichten 7, 9 der zweilagigen Leiterfolie miteinander kontaktiert werden können. Der Lochdurchmesser dieser kleinen Durchgangslöcher 14, 14' beträgt weniger als 100µm bis hinunter zu 20µm. Diese in Figur 6e schematisch abgebildete zweilagige Folienleiterplatte, mit dünnen Metallschichten 7, 9, mit einer dünnen intermediären Nichtmetallschicht 8' und mit kleinen Durchgangslöchern 14, 14', ist eine beispielhafte Ausführungsform eines Halbzeugs zur Verwendung für mehrlagige Leiterplatten mit Durchplattierungen. Es handelt sich insofern um ein Halbzeug, da die Durchgangslöcher 14, 14' noch nicht elektrisch leitende Verbindungen in Form von Durchplattierungen zwischen den Metallschichten 7, 9 darstellen und der ganze Schaltungsentwurf, d.h. die Strompfade noch nicht definiert sind. Die Durchgangslöcher 14, 14' sind lediglich photomechanisch gebohrte und vorgearbeitete Durchplattierungen, die im Layout verwendet werden können oder nicht. Bei Universalrastern kann das Halbzeug zwischengelagert werden, bei spezifischen Layouts kann es in einem Zuge weiterverarbeitet werden. Dies ist in den Figuren 6f bzw. 6g gezeigt.

In Figur 6f erfolgt eine durchgehende Metallisierung sowohl der inneren Oberflächen der Durchgangslöcher 14, 14' als auch der äusseren Oberflächen der Metallschichten 7, 9 des Halbzeugs. Es handelt sich hierbei beispielsweise um eine galvanisch erzeugte Verstärkung der Metallschichten 7, 9, diese Metallschichten heissen daraufhin verstärkte Metallschichten 7', 9'. Andererseits erhalten hierdurch die Durchgangslöcher 14, 14' eine Aufplattierung, derart, dass sie elektrisch leitenden Verbindungen zwischen den verstärkte Metallschichten 7', 9' bilden. Diese aufplattierten Durchgangslöcher 14, 14' werden Durchplattierungen 17, 17' genannt. Das Produkt ist in dieser Form immer noch ein Halbzeug, bereit zur Realisierung des Layouts.

Figur 6g zeigt, wie das Halbzeug aus Figur 6e bzw. 6f nach erfolgter photochemischer Strukturierung (Layout) der Lagen 7', 9' zur Leiterplatte fertiggestellt wird. Gemäss einem Schaltungsentwurf werden die Strompfade 18 als Verdrahtungsbild herausgeätzt und somit eine zweilagige Folienleiterplatte 19 hergestellt. Das Metall zwischen den Leitern wird bis auf die Oberflächen 8.1',8.2' der dünnen intermediären Nichtmetallschicht 8' heruntergeätzt, sodass Strompfade 18 von der intermediären Nichtmetallschicht 8' getragen werden und von den Oberflächen 8.1', 8.2' gegeneinander elektrisch isoliert bis an die Mündungen der Durchplattierungen 17, 17' herangeführt werden können.

Die Verfahrenschritte 6a bis 6e bzw. 6f zur Herstellung eines erfindungsgemässen Halbzeugs und (mit den Schritten 6f und 6g) einer Leiterfolie 19 daraus, beinhalten ausgereifte bekannte und bewährte und damit risikolose Techniken der Leiterplatten-Industrie. Sie können von einem Fachmann bei Kenntnis der vorliegenden Erfindung auf gängigen Apparaturen ausgeführt werden. Das erfindungsgemässe Verfahren hat den Vorteil, dass alle Verfahrensschritte in allen Oberflächenbereichen der Leiterfolie gemäss den Figuren 6a bis 6d, sowie des Halbzeugs gemäss den Figuren 6e bis 6g zeitgleich durchgeführt werden. Daher wird auch auf allen dem Plasma-Ätz-Medium exponierten Bereichen, in dem Beispiel auf beiden Seiten des Halbzeugs gleichzeitig geätzt. Demgemäss kann man beispielsweise bei Verwendung sehr dünner Photolacke diese gleichzeitig mit dem Plasma-Ätzen der Durchgangslöcher 14, 14' entfernen. Es können zehntausende von Löchern gleichzeitig plasma-geätzt oder, besser gesagt, plasma-gebohrt werden. Die Ätzdauer wird bei zwei gleichzeitig geätzten Seiten eines Halbzeugs halbiert. Auch auf beiden Seiten gleichzeitig unterschiedliche Strukturen plasma-geätzt werden. Gemäss dem Layout können beispielsweise auf einer Seite Durchplattierungen und auf der anderen Seite Sacklöcher gleichzeitig, in einem Verfahrensschritt geätzt werden. All diese einzigartigen Vorteile des Folienätzens reduzieren die Herstellungskosten beträchtlich. Dies ist zu unterscheiden vom zeitlich nacheinander ablaufenden mechanischen Aufbohren oder auch Laserbohren von Durchgangslöchern und Sacklöchern. Solche Verfahren kennzeichnen sich durch viele Prozessschritte, vergleichbar schlechte Ausbeuten, hohe Kosten.

Die Materialien, die verwendet werden, sind einfach und kostengünstig. Zur Verwendung kommen dünne mit Metall beschichtete Folien, beispielsweise mit dünner Kupferfolie (3 bis 70µm dick) beschichtete dünne, nichtausgehärtete Polyimid-Folien oder Epoxydharz-Folien (12 bis 100µm dick). Zur Herstellung des Ausgangsmaterials für dreischichtige Folien gemäss Figur 6a werden die Schichten beispielsweise auf einfache Weise durch Pressen und Temperatur mechanisch miteinander verbunden, derart, dass eine intermediäre Nichtmetallschicht vorliegt, welche die beiden Metallschichten elektrisch voneinander isoliert. Andere Verfahren zur Herstellung solcher Folien sind bekannt und werden grosstechnisch eingesetzt. Auf dem Markt werden auch dünne Metall/Nichtmetallfolien aus diesen Materialien (∼100µm dick) angeboten. Zur Herstellung einer dreischichtigen Folie gemäss Figur 6a wird eine solche dünne Metall/Nichtmetallfolien auf einfache Weise durch Pressen und Temperatur mechanisch mit einer dünnen Kupferfolie verbunden, derart, dass eine intermediäre Nichtmetallschicht vorliegt, welche die beiden Metallschichten elektrisch voneinander isoliert.

Um bei hochfrequenten Anwendungen (bis zu Frequenzen >1GHz) unerwünschte Effekte, wie hohe Dämpfungen, Reflexionen oder Übersprechen von Signalen zu verhindern, ist es notwendig, nicht nur die Abstände der Signallagen und der Erdungslagen, sondern auch deren Breiten in bestimmten engen Grössenbeziehungen gestalten. Die gleichmässige Dicke der Dielektrikumschichten, die kleinen Dämpfungswerte und Dielektrizitätskonstanten der verwendeten Folien und auch die engen Toleranzbreiten der Dielektrizitätskonstanten der verwendeten Folien in x- und y-Richtungkommen diesen Erfordernissen der Hochfrequenztechnik hervorragend entgegen. Die vorliegende Erfindung führt demgemäss zu Leiterplatten, die aufgrund der dünnen Metall- und Nichtmetallschichten (jeweils 12 bis 150µm dick) und den kleinen Durchplattierungen (Durchmesser kleiner 100µm) hervorragend für Anwendungen im Hochfrequenzbereich geeignet sind. Dies ist von grosser technischer Bedeutung, da die Tendenz dahingeht, dass beispielsweise Personal Computers (PCs) nicht nur in der zentralen Recheneinheit sehr hoch (mehrere Hundert Mega-Hertz) getaktet arbeiten, sondern dass auch für das Bussystem auf den Leiterplatten diese Taktfrequenzen angestrebt werden. Mit gängigen Leiterplatten ist dies aufgrund der makroskopischen Dimensionen von Lagendicken und Leiterbreiten, wie auch aufgrund der wechselnden Zusammensetzung und wechselnden Dicke des Dielektrikums aus Glasfasergewebe und der wechselnden Dicke der Matrix aus Epoxyd- oder Polyimid-Harz, schwerlich möglich.

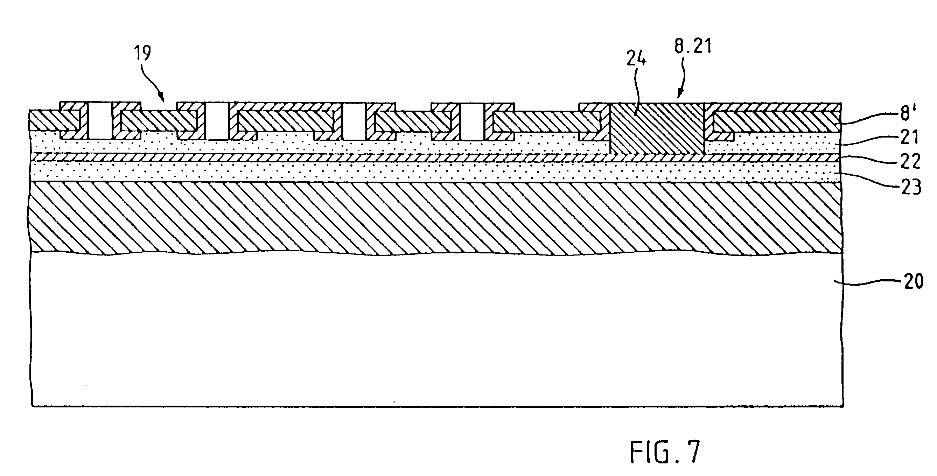

In **Figur 7** ist eine beispielsweise Ausführungsform eines Teils einer Leiterplatte, hergestellt aus einem Halbzeug nach dem erfindungsgemässen Verfahren, zu sehen, welche mit einem mechanischen Träger verbunden ist. Eine der Eigenschaften der Leiterplatten nach dem erfindungsgemässen Verfahren ist die, dass sie sehr dünn sind. Sie können flexibel oder auch starr sein. Sobald die mechanische Festigkeit Eingang finden soll, muss, man hat diese Funktionen ja wissentlich getrennt, die Festigkeitsfunktion eingebracht werden. In diesem Fall wird eine Verbindung mit einem mechanischen Träger vorgesehen, beispielsweise zur Fixierung dieser Leiterplatte in einem Gehäuse, oder zur Abfuhr der von den Bauelelementen dieser Leiterplatte generierten Wärme und so weiter. Eine solche Leiterfolie kann durch Auflaminieren oder Aufkleben auf einen mechanischen Träger zur Leiterplatte verarbeitet werden.

Eine nach dem erfindungsgemässen Verfahren (siehe Figur 6) aus einem Halbzeug hergestellte Leiterplatte 19 kann vor oder nach einer solchen Montage auf einen mechanischen Träger mit Bauelementen bestückt werden. Vorteilhafterweise rüstet man eine solche Leiterplatte oder Teil-Leiterplatte 19 zumindesten soweit aus, dass sie in den Bereichen, die nach der Montage mit einem mechanischen Träger nicht mehr oder nur schwer zugänglich sind, schon fertig gestellt ist. Wenn, wie in Figur 7 zu sehen, eine Seite einer dünnen Teil-Leiterplatte 19 mit einem mechanischen Träger verbunden wird, kann beispielsweise diese verdeckte Seite vorher bestückt werden.

Ein mechanischer Träger 20 kann aus Metall, aus Kunststoff, auch aus Keramik, aus präpariertem Papier, aus präpariertem Karton etc. bestehen. Er kann auf seiner Oberfläche mit einer elektrischen Stromversorgung 22 beispielsweise in Form einer Versorgungsschicht versehen sein. Die Versorgungsschicht 22 ist derart strukturiert, dass sie elektrisch voneinander isolierte Leiterbahnen aufweist, welche die Übertragung von technischen Gleichspannungen ermöglichen. Man kann eine solche Versorgungsschicht 22, wie in Figur 7 zu sehen, herstellen, indem man eine dünne, fertig strukturierte Teil-Leiterplatte oder Halbzeug-Folie 19 einseitig mit Klebefolien aus beispielsweise Acryl-, Epoxyd- oder Polyimid-Harz mit einem mechanischen Träger oder Trägerplatte 20 durch Anwendung von Druck und Temperatur verklebt. Die Trägerplatte kann an ihrer Grenzfläche zur Halbzeug-Folie 19 eine elektrisch funktionelle Leiterebene aufweisen, die vorab auf der Trägerplatte 20 nach den üblichen Verfahren der Leiterplattentechnik erzeugt wurde. Vorteilhafterweise trägt die Trägerplatte 20 nur grobe Leiterstrukturen, wie beispielsweise Versorgungsleiter bzw. Flächen. Der stabile, im Verhältnis zur dünnen Leiterplatte 19 und der Versorgungsschicht 22, dicke mechanische Träger 20 wird, falls nötig, über die eine Kunststoff-Folie 21 von der Versorgungsschicht 22 elektrisch isoliert.

Um die Versorgungsschicht 22 zur elektrischen Stromversorgung der Leiterplatte 19 zu verwenden, sind natürlich eine gewisse Anzahl elektrischer Verbindungen zwischen der Versorgungsschicht 22 und der Leiterplatte 19 notwendig. Um dies zu realisieren, werden im gleichen Arbeitsgang wie zur Herstellung der Durchplattierungen oder Mikro-Durchgangslöcher 17 (hierfür siehe Figuren 6a bis 6g), grössere Löcher 8.21 in der intermediären Nichtmetallschicht 8' hergestellt. Deren Durchmesser betägt 200 bis 400µm. Verwendet man zum Verkleben der Halbzeug-Folie 19 mit der Trägerplatte 20 eine an den Positionen der Löcher 8.21 vorgebohrte Klebefolie aus Acryl- oder Epoxyd-Harz, so entstehen an diesen vorgegebohrten Positionen die Löcher 8.21, welche bis auf die Versorgungsschicht 22 hinunterreichen. Beispielsweise durch Aufbringen von Lötzinn oder beispielsweise durch Aufplattieren einer metallischen Form in diese Löcher können die Leiterplatte 19 und die Versorgungsschicht 22 über stromversorgende Durchplattierungen 24 miteinander kontaktiert werden. Der Lochdurchmesser dieser stromversorgenden Durchplattierungen 24 muss nicht minimalisiert werden, da meist nur eine beschränkte Anzahl solcher stromversorgenden Durchplattierungen 24 benötigt werden.

Demgemäss kann durch das erfindungsgemässe Verfahren eine Trennung zwischen möglichst klein dimensionierten Strompfaden für die Übertragung hochfrequenter Signale einer dünnen beispielsweise zweilagigen Leiterplatte 19 mit dementsprechend möglichst klein dimensionierte Durchplattierungen zwischen den Leiterebenen der Leiterplatte 19 und von den stromversorgenden Zuleitungen mit technischen Stömen und beispielsweise niedervoltigen Gleichspannungen über eine Versorgungsschicht 22 und schliesslich der mechanischen Trägerschicht realisiert werden. Wie in Figur 7 dargestellt, setzt sich eine gemäss Beispiel gefertigte Leiterplatte aus drei Komponenten zusammen: einer hochverdichteten Leiterplatte 19 für die Signalebene, einer weniger verdichteten elektrischen Stromversorgung 22 und einem mechanischen Träger 20 als Festigkeits- und/oder Kühlebene.

Der Vorteil einer solchen Montage liegt darin, dass aus einer zweilagigen Folienleiterplatte die aus einer dreischichtigen Folie (siehe Figur 6a) und einem Halbzeug (siehe Figur 6e) nach dem erfindungsgemässen Verfahren gemäss der Beschreibung zu Figur 6 hergestellt ist, durch nachträgliches Anbringen weiterer Metall- und Nichtmetallschichten mehrlagige Leiterplatten erzeugt werden können. In der beispielhaften Ausführungsform gemäss Figur 7 liegt demgemäss eine dreilagige Leiterplatte vor, die auch noch über einen externen mechanischen Träger verfügt. Auch hier gilt, dass die hierfür notwendigen Verfahrensschritte bekannte und bewährte Techniken der Leiterplattenindustrie sind. Sie können also von einem Fachmann bei Kenntnis der vorliegenden Erfindung auf gängigen Apparaturen ausgeführt werden.

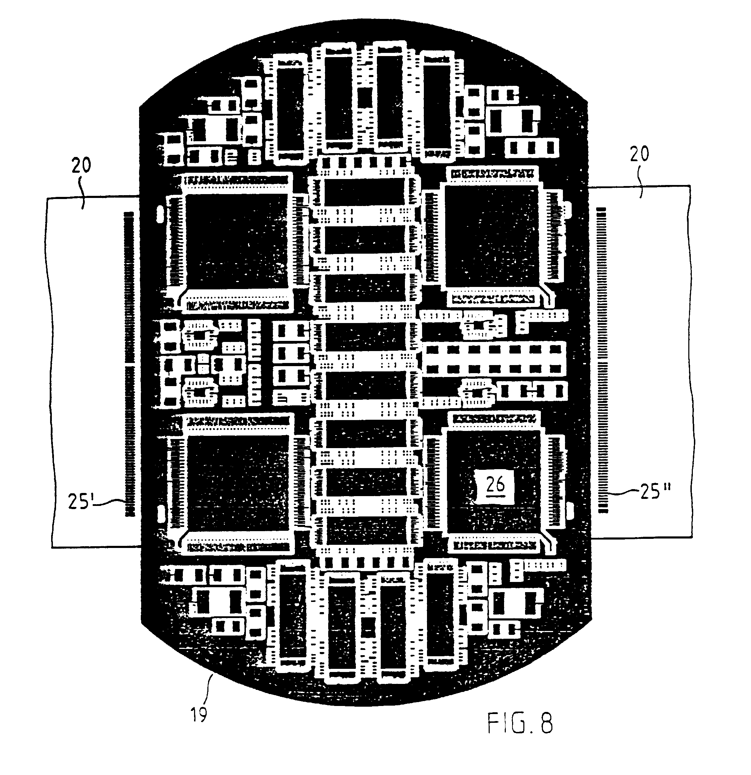

**Figur 8** zeigt eine hochintegrierte, fertig bestückte Leiterplatte, ein MCM, die aus einem Halbzeug nach dem erfindungsgemässen Verfahren hergestellt ist. Die Abbildung findet mit rund 1,5-facher Vergrösserung statt. Eine flexible oder starre dünne Leiterplatte 19 (beispielsweise als zweilagige Leiterplatte gemäss der Beschreibung zu Figur 6 fabriziert) ist mit mehreren Bauelementen 26 bestückt. Diese Bauelemente können mehr oder weniger komplex sein, mit einer kleineren oder grösseren Anzahl notwendiger elektrischer Verbindungen für die Stromversorgung und mit mehr oder weniger vielen kontaktierten Strompfaden (beispielsweise über die Strompfade 18 gemäss Figur 6g). Diese Strompfade verlaufen vorteilhafterweise auf den beiden Ebenen der Leiterplatte 19 und verbinden die Bauelemente 26 miteinander. Die Strompfade verschiedener Ebenen können über Durchplattierungen (beispielsweise über die Durchplattierungen 17, 17' gemäss Figur 6g) miteinander im elektrischen Kontakt stehen. Die Verbindungen für die Stromversorgung der Bauelemente 26 haben über stromversorgende Durchplattierungen (beispielsweise über die stromversorgenden Durchplattierungen 24 gemäss Figur 7) elektrischen Kontakt mit Leiterbahnen einer Versorgungsschicht (beispielsweise die Versorgungsschicht 22 gemäss Figur 7). Diese Versorgungsschicht ist in Figur 8 nicht zu sehen, sie liegt in dieser Ansicht unter der Leiterplatte 19 und wird durch sie verdeckt. Die Leiterplatte 19 weist Kontaktstellen 25', 25" auf, über die die Leiterplatte 19 beispielsweise mit anderen Leiterbahnen oder Bauelementen elektrisch kontaktiert werden kann. Die Leiterplatte 19 und die Versorgungsschicht sind auf einem externen mechanischen Träger 20 (beispielsweise auf einen mechanischen Träger 20 gemäss Figur 7) montiert. Derart kann diese Einheit bestehend aus Leiterplatte 19, Versorgung 22 und Träger 20 in beliebige andere Geräte eingebaut werden.

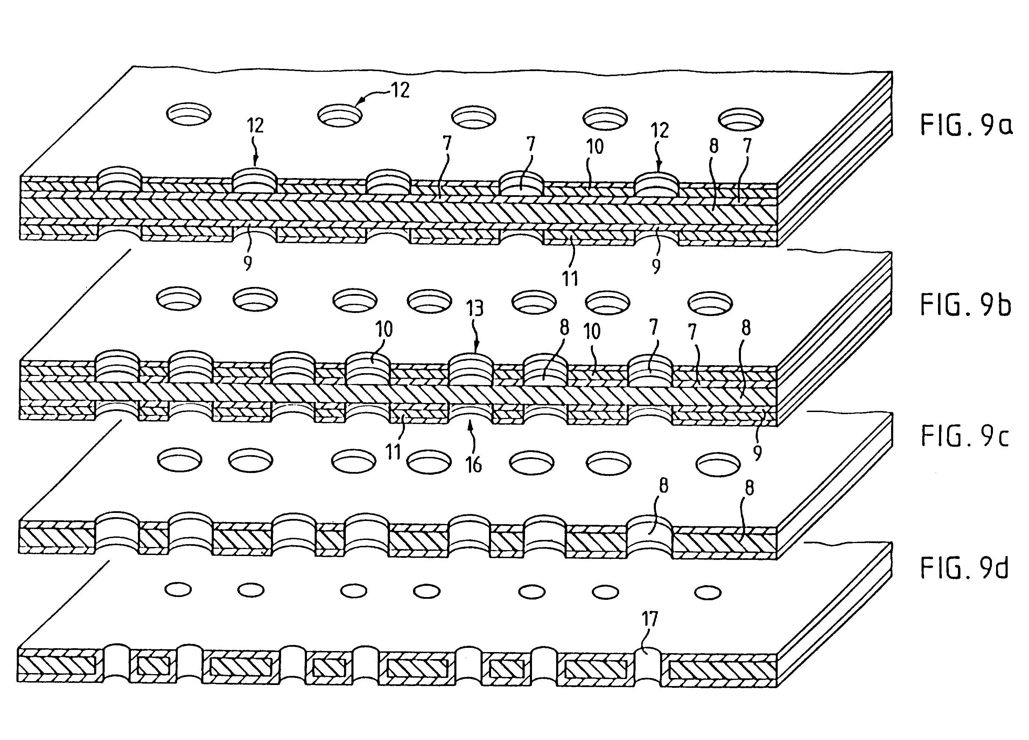

Die **Figuren 9a-d** zeigen nun in einer Sequenz a bis d die beispielsweise Herstellung eines Universalsubstrates als Halbzeug. In Figur 9a ist eine beidseitig mit Kupfer 7,9 beschichtete Folie 8 dargestellt, die ein regelmässiges Muster von Sacklöchern 12 in einer beidseitigen Ätzresistschicht 10,11 bis zur Kupferschicht 7,9 zeigt. Solch ein Lochbild, universell oder layoutorientiert, wird auf eine Ätzresistschicht belichtet, entwickelt und geätzt. Nach dem Aetzen des Kupfers der Kupferschichten 7,9, wie in Figur 9b gezeigt, entstehen Ausnehmungen oder Fenster 13,16, es sind auch Sacklöcher, in welchen die Kunststoffolie 8 freigelegt ist. Die Ätzresistschichten 10,11 werden entfernt und in diese, in der Kupferschichten 7,9 freigelegten Stellen der Folie 8 werden, wie in Figur 9c gezeigt, die Durchführung bzw. Löcher durch die Folie mit einem weiteren Ätzprozess, bspw. einem Plasma-Aetzprozess hindurch geätzt, so, wie dies im Zusammenhang mit den Figuren 6a bis 6e bereits im Detail diskutiert wurde.

Nach dem Plasmaätzen werden die Löcher galvanisch mittels Kupfer durchplattiert, oder auch mittels anderer Methoden elektrisch durchverbunden (Figur 9d). Die Durchplattierung ist mit der Ziffer 17 bezeichnet. Durch die Durchplattierung wird der Lochdurchmesser wieder kleiner, wobei bspw. zu Kühlzwecken oder für einen einfacheren Durchplattierungsprozess diese Löcher auch ausgefüllt sein können. Sehr kostengünstig arbeitet beispielsweise ein Siebdruckverfahren, mittels welchem elektrisch leitfähiges Material, leitfähige Paste in die Löcher eingebracht und anschliessend gehärtet wird, oder mittels eines kopierähnlichen Verfahrens, bei dem leitfähiger Toner in die Löcher eingebracht und durch Wärme (Schmelzen des Toners) verfestigt wird. Man kann Durchplattierungen herstellen, in denen die Löcher erhalten bleiben, bspw. durch Aufdampfen von Lot (Zinnlot), wobei die Kupferschicht zwischen den Löchern mit überzogen werden kann.

Nun hat man eine beidseitig metallbeschichtete, in zwei Dimensionen elektrisch leitfähige Folie mit den durchplattierten Löchern (Figur 9d), wie sie später im gewünschten Leiterbild dann über Lötaugen mit Leiterbahnen kontaktiert werden. Diese Leiterbahnen werden in einem zweiten Belichtungs- und Ätzprozess erzeugt, welcher dann im Herstellungsprozess für Leiterplatten unter Verwendung des Universalsubtstrats als Vor- oder Halbfabrikat hergestellt wird. Das fertige Halbfabrikat ist in diesem Beispiel auf eine Rolle aufgewickelt.

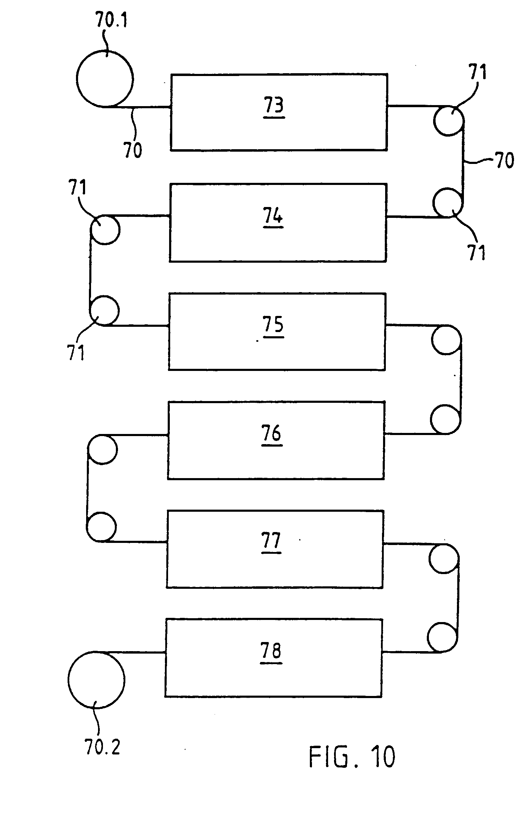

**Figur 10** zeigt schliesslich, wie Halbzeuge, Universalleiterplatten, Leiterplatten u.s.f mit durchplattierten Kontakten auf Bandanlagen im Fliessverfahren hergestellt werden können. Der Vorteil von kontinuierlich ablaufenden Verfahren besteht darin, dass Folien von Rolle zu Rolle verarbeitet werden können. Das Aetzen von Löchern in beidseitig beschichtete Kunststoffolien, so wie es z.B. in den Figuren 6a bis 6g und 9a bis 9d dargestellt und beschrieben ist, kann mit einer Bandanlage dieser Art erfolgen. Auch das Aufbringen des Leiterbildes kann in einem Fliessprozess durchgeführt werden. Ferner kann das Laminieren von fertigen Leiterplatten mit einseitig metallbeschichteten Folien mit einer Klebefolie ebenfalls ab Rolle erfolgen, sodass bis zu einem gewissen Grad Multilayer ab Rolle gefertigt werden können. Die hier vom Prinzip her beschriebene Bandanlage kann für den Vorprozess der Halbfabrikatherstellung und für den Hauptprozess der Leiterplättenherstellung verwendet werden. Auf diese Weise kann eine Anlage auch besser ausgelastet werden.

Von einer Vorratsrolle 70.1 wird die Kunststoffolie 70, die beidseitig mit einer Schicht aus Metall versehen ist, über verschiedene Verfahrenschritte und Transportrollen 71 letzlich einer Aufnahmerolle 70.2 zugeführt, die das fertige Produkt, nämlich die gelochte Folie, aufnimmt. In einem ersten Verfahrensschritt wird mittels herkömmlicher Beschichtungsverfahren 73 wie Aufrollen, Aufsprühen, Tauchbeschichtung oder elektrophoretischer Abscheidung die Kunststoffolie 70 beidseitig mit einer Schicht aus Photoresist versehen. In einem Durchlaufofen 74 wird anschliessend die Schicht getrocknet. Dann erfolgt die notwendige Strukturierung des Lochmusters durch Belichtung in einem UV-Belichter 75 mit anschliessender Entwicklung in einer Entwicklungsanlage 76. Daraufhin wird in einem Metallätzer- und Photolackstripper 77 zuerst die Schicht aus Metall an den Ausnehmungen, wo Durchgangslöcher oder Löcher entstehen sollen, weggeätzt und dann der übriggebliebene Photoresist entfernt. Schliesslich werden in einem Plasmareaktor 78 die Durchgangslöcher und/oder Löcher herausgeätzt.

Der darin eingeschlossene Durchplattierungsprozess kann mittels herkömmlicher Bandgalvanik oder aber auch durch Eindrücken elektrisch leitfähigem Materials in die Löcher bzw. Aufdampfen oder Aufsputtern metallischer Schichten bewerkstelligt werden.

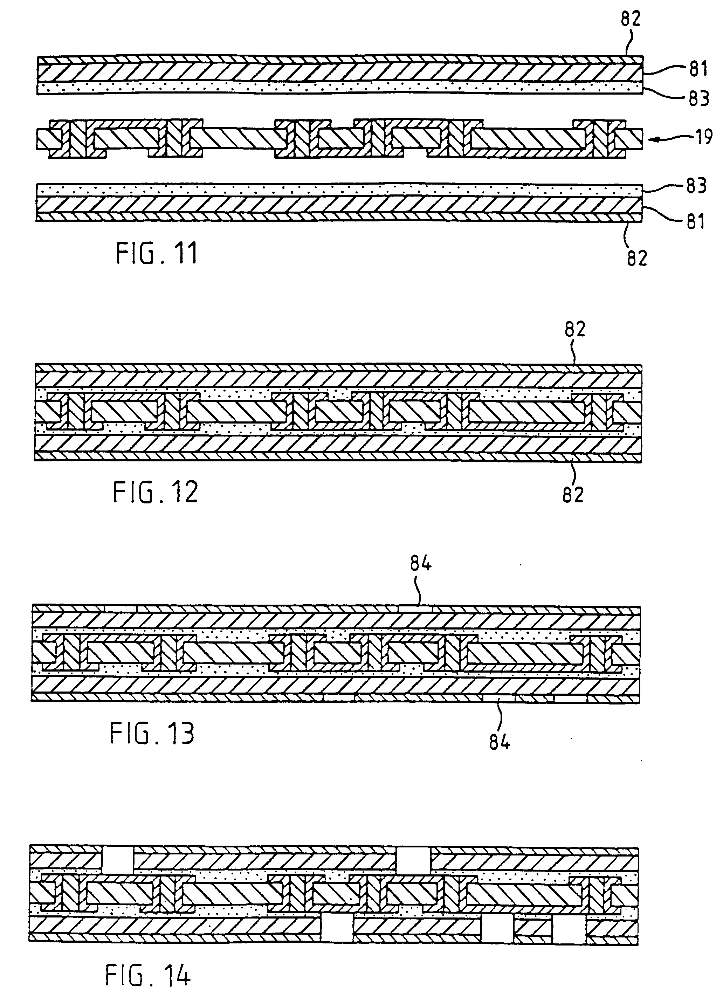

Nachdem nun gezeigt wurde, wie man eine Vielfalt verschiedener Durchführungen in Kunststoffolien anlegt, welche anschliessend durchkontaktiert werden können, zeigt nun die folgende Sequenz von **Figuren 11 bis 16**, wie man mit dem diskutierten Vorgehen eine vierlagige Filmleiterplatte aufbaut.

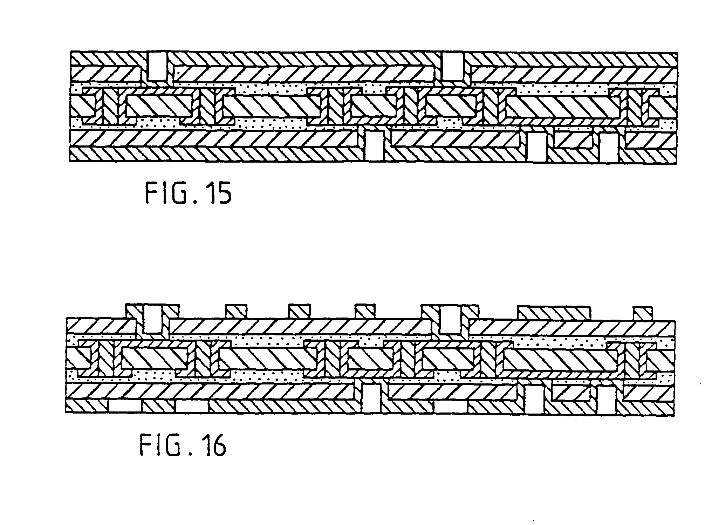

Eine gemäss Figuren 6a bis 6g hergestellte Filmleiterplatte 19 wird beidseitig mit einer einseitig metallbeschichteten Folie 81,82 versehen. Dies geschieht bspw. mittels einer Klebefolie 83. Figur 11 zeigt das entsprechende Ensemble vor dem Laminieren, nämlich die Filmleiterplatte 19 und auf beiden Seiten, oben und unten je eine Folie 81 mit Metallschicht 82 und Kleber 83. Nach dem Auflaminieren auf die Leiterplatte erhält man eine ca. 3-fach dicke Folie, die auf beiden Seiten eine Metallbeschichtung 82 aufweist und im Kernbereich die früher gefertigte Folie 19 gemäss Figur 6g eingeschlossen enthält (gezeigt in Figur 12). Man hat nun wieder die gleiche Ausgangslage, wie sie in Figur 6a dargestellt ist, ein Vor- oder Zwischenfabrikat, auf das ein bestimmtes Leiterbild aufgebracht und in das bestimmte Durchätzungen eingebracht werden sollen. Wie in früheren Herstellungsschritten werden auf die beiden metallbeschichteten Seiten mittels eines Photoprozesses die Muster für die Durchplattierungen aufgebracht, was Figur 13 zeigt. Und nun kommt die Herstellung von Sacklöchern, die analog zu den Durchätzungen beschrieben im Zusammenhang mit den Figuren 6a bis 6e hergestellt werden: nach dem Plasmaätzen hat man das Muster von Sacklöchern, die auf die Leiterbahnenschicht der im Inneren des Verbundes eingeschlossenen Filmleiterplatte 19 führen. Figur 14 zeigt solche Anschlusslöcher 84 und Figur 15 zeigt diese nach dem Durchplattieren mit einer Metallschicht. So reichen in dem gezeigten Beispiel auf der einen Seite zwei und auf der anderen Seite drei Sacklöcher in die Zwischenebene mit der Leiterplatte 19. Mittels eines weiteren Photoprozesses wird schliesslich das Leiterbild erzeugt und man hat nun einen 4-lagigen Film-Multilayer gemäss Figur 16. So kann durch Wiederholung der Verfahrensschritte gemäss Fig. 11 bis 16 eine 5- oder 6-lagige Leiterplatte und so weiter, auf einer der beiden oder auf beiden Seiten des Produktes aufgebaut werden. Dieser Prozess kann solange weitergeführt werden, wie man Schichten in einer mehrlagigen Leiterplatte vorgesehen hat. Er weist alle die, in der Beschreibung zu den Figuren 6a bis 6g erwähnten Vorteile auf, die aus dem gleichzeitigen Ätzen mehrerer Seiten der Leiterplatte entstehen.

Einen grossen Vorteil dieses Verfahren erkennt man schon in den Verfahrensschritten gemäss den Figuren 11 bis 16; es hat keine "langen" Durchführungen oder Durchplattierungen, diese reichen jeweils "eine Schicht tief' und können deshalb mit der grössten Präzision, die möglich ist, realisiert werden, weil anschliessend wiederum nur die Präzision über eine Schicht hinweg eingehalten werden muss. Es entsteht so keine Toleranzfehlerkette, wie sie bei der Stapelung von Multilayern nach üblicher Bauweise auftritt (und Ausschuss produziert). Ferner führt die Vermeidung von langen Durchplattierungen zu einem besseren thermischen Verhalten. Die gemäss Erfindung aufgebauten Multilayer verhalten sich gegen Temperaturschwankungen robuster.

Falls durch eine grössere Anzahl von Verfahrensschritten entstehende Produkte, die durch Aufbringen von immer mehr Schichten ständig dicker werden, irgend wann während ihrem Entstehen vereinzelt und als Stückgut weiterverarbeitet werden müssen, da sie wegen zu hoher Steifigkeit nicht mehr über Rollen geführt oder aufgerollt werden können. Das heisst aber auch, dass unter Umständen ein Teil der Herstellungsschritte am quasi endlosen Material und ein Teil der Herstellungsschritte, die die genau gleichen Schritte sein können, am Stückgut durchgeführt werden müssen. Es bedeutet also, dass die Verarbeitungsart (Rolle-zu-Rolle oder Stückgut) nur vom Produkt abhängig ist und nicht vom Verarbeitungsschritt, dass also unter Umständen ein Verarbeitungsschritt, der sich hervorragend für eine Rolle-zu-Rolle-Verarbeitung eignen würde, mit Stückgut betrieben werden muss, nur weil das zu verarbeitende Produkt nicht aufgerollt werden kann (bspw. kritische Biegeradien).

Um diesen Effekt zu mildern kann eine weitere Massnahme die Rolle-zu-Rolle Fertigung unterstützen. Dabei werden Ausgangsmaterialien und/oder Zwischenprodukte derart konditioniert, dass sie mindestens in einem Teil der Verarbeitungsschritte als quasi endloses, gelenkiges Band oder Faltwurm verarbeitet werden können und dass Zwischen- und/oder Endprodukte als Faltstapel gestapelt werden können, wie dies vom Endlospapier bekannt ist.

Die Vorteile des Faltstapels gegenüber der Rolle sind vor allem die, dass im Faltstapel das Produkt nicht unter Spannung steht und nicht gebogen ist. Die effektive Verarbeitung des Faltstapels unterscheidet sich dabei wenig von der effektiven Verarbeitung von und auf Rolle, es sei denn, das Produkt durchlaufe einen Verarbeitungsschritt in mehr oder weniger eng gefalteter Formation.

Die Bildung eines "Faltwurmes" aus quasi endlosem Folienmaterial besteht darin, dass in diesem Material, das aus einer Kunststoffolie oder mehreren, aufeinanderliegenden Kunststoffolien mit darauf- und/oder dazwischenliegenden Metallschichten bzw. Leiterbahnenlagen besteht, quer zu seiner quasi endlosen Ausdehnung durch entsprechende Schwächung entlang vorteilhafterweise äquidistanten Linien Sollknickstellen erzeugt werden. Die Bildung eines Faltwurmes aus Folienmaterial in Stückgutform besteht darin, dass die einzelnen Stücke mit einer knickbaren Verbindung (flexible Verbindung) miteinander zu einer quasi endlosen Reihe verbunden werden. Das stückgutförmige Folienmaterial kann dabei Grundmaterial oder nach anderen Verfahren hergestelltes Zwischenprodukt sein.

Die Sollknickstellen im quasi endlosen Material werden durch Materialschwächungen, beispielsweise Perforierungen oder Dickenverminderungen zusammen mit funktionsrelevanten Öffnungen, wie beispielsweise Offnungen für Durchplattierungen oder Sacklöcher, in denselben Verarbeitungsschritten, vorteilhafterweise durch Plasmaätzen erstellt. In demselben Ätzschritt können auch für einen Transport mittels Stachelradanordnung notwendige Lochreihen entlang den Längskanten des Materials erstellt werden. Dies bedeutet, dass die Herstellung der Sollknickstellen und der Transportlochreihen keine zusätzlichen Verfahrensschritte erfordert. Dadurch ergibt sich der weitere Vorteil, dass die Toleranz zwischen Sollknickstellen bzw. Transportlochreihen und funktionsrelevanten Öffnungen auf ein absolutes Minimum beschränkt bleibt, derart, dass die Sollknickstellen und/oder die Transportlochreihen auch als Ausrichthilfen für weitere Verarbeitungsschritte dienen können.

Die flexiblen Verbindungen zur Verbindung von stückgutförmigem Folienmaterial werden beispielsweise durch Anbringen von Kleberfolien in einem separaten Arbeitsschritt erstellt. Nach der Herstellung der flexiblen Verbindungen können in der oben beschriebenen Art Transportlochreihen geätzt werden, die auch hier vorteilhafterweise zusammen mit funktionsrelevanten Offnungen geätzt werden und damit als Ausrichthilfen verwendet werden können.

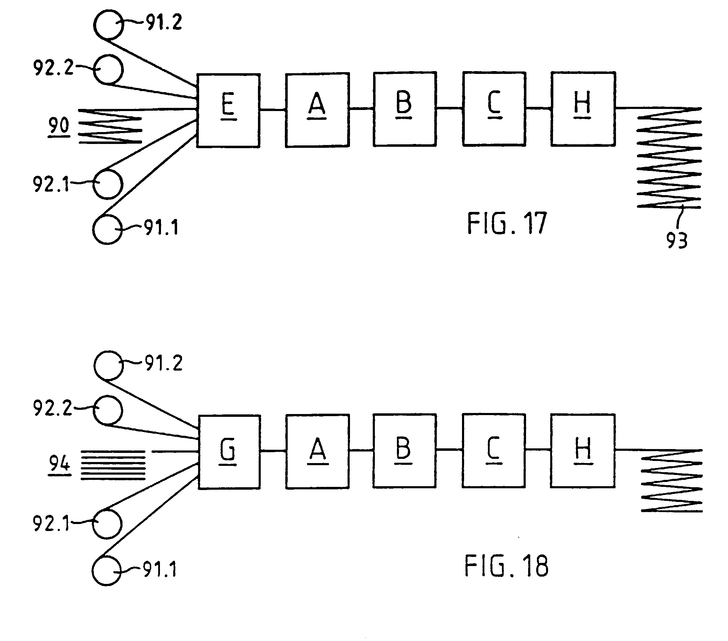

**Figur 17** zeigt eine Form der Weiterverarbeitung eines bereits als Faltstapel vorliegenden Produktes. Auf die Leiterplatten mit zwei Leiterbahnenlagen (Faltstapel 90) werden in einem Verfahrensschritt E beispielsweise beidseitig eine einseitig metallbeschichtete Folie auflaminiert. Die einseitig beschichteten Folien werden ab Rollen 91.1 und 91.2 eingespeist, ebenso je eine Kleberschicht zur Verbindung der verschiedenen Folien, die ab Rollen 92.1 und 92.2 eingespeist werden. Es folgen dieselben Verfahrensschritte A, B, C und H, wie bereits im Zusammenhang mit den Figuren 11 bis 16 beschrieben, in denen die auflaminierten Folienlagen bearbeitet werden. Dabei können in den Verfahrensschritten A und B, nicht nur funktionsrelevante Öffnungen, z.B Sacklöcher zur Verbindung der äusseren Leiterbahnenlagen mit den inneren, in die Kunststoffolien geätzt werden, sondern wiederum auch Öffnungen oder teilweise Abtragungen zur Schwächung des Materials an den Sollknickstellen, deren Lage durch die bereits bestehenden Sollknickstellen im Produkt 90 vorgegeben sind. Es können auch wieder Transportlochreihen erzeugt werden.

Nach diesem Verfahren entsteht eine quasi endlose Serie von durch Sollknickstellen verbundenen, Folienleiterplatten mit vier Leiterbahnenlagen, die als Faltstapel 93 abgelegt wird. Dieser Stapel kann beispielsweise direkt in eine Apparatur zur automatisierten Bestückung eingespeist werden, in der die einzelnen Leiterplatten dann auch vorteilhafterweise voneinander getrennt und die Bereiche mit den Transportlochreihen abgetrennt werden. Es kann sich aber auch um ein Halbzeug handeln, dessen äussere Leiterbahnenlagen noch individualisiert werden oder das mit weiteren Folienlagen zu Folienleiterplatten mit mehr als vier Leiterbahnenlagen verarbeitet wird.

Eine Variante besteht darin, dass bei entsprechend kleiner Eigensteifigkeit der Folien ab Rollen 91.1 und 91.2 im Verfahren gemäss Figur 17 keine Öffnungen oder Materialabtragungen für die Sollknickstelle angebracht werden, das heisst, dass die Sollknickstellen im Faltstapel 90 genügen, um auch das aus drei Folienlagen bestehende Produkt zu einem Faltstapel zu falten.

**Figur 18** zeigt eine weitere Variante des oben angesprochenen Hilfs-Verfahrens. Stückgutförmiges Folienmaterial 94, beispielsweise noch unbearbeitete Folien oder Zwischenprodukte mit einer oder mehreren Folienlagen, wird in einen Verarbeitungsschritt G gespeist. Auf das stückgutförmige Folienmaterial 94 soll beispielsweise beidseitig je eine weitere Folienlage ab Rollen 91.1 und 91.2 mit Hilfe von Kleberschichten ab Rollen 92.1 und 92.2 auflaminiert werden. Durch Zusammenlaminieren des stückgutförmigen Zwischenproduktes mit den quasi endlosen, flexiblen Folien ab Rollen 91.1 und 91.2 entsteht ein Faltwurm, der in den folgenden Verarbeitungsschtritten A, B, C, H in im Zusammenhang mit den vorgehenden Figuren bereits beschriebener Weise bearbeitet werden kann.

Ist das ab Rollen 91.1 und 91.2 gelieferte Folienmaterial etwas breiter als das stückgutförrnige Folienmaterial 94 und besitzt es Transportlochreihen, kann der entstehende Faltstapel mit Hilfe von Stachelrädern transportiert werden. Entsprechende Transportlochreihen können auch in den Verarbeitungsschritten A und B hergestellt werden.

## Patentansprüche

1. Verfahren zur Herstellung von mehrschichtigen Leiterplatten mit extrem dichter Verdrahtung aus einem Ausgangsmaterial mit einer mit mindestens einer stromleitenden Schicht (7,9) belegten stromisolierenden Folie (8) mit einer Dicke kleiner 500 µm,
mit folgenden Verfahrensschritten:
mittels eines ersten photochemischen Verfahrensschrittes werden Öffnungen (13,13',16,16') in der mindestens einen stromleitenden Schicht (7,9) vorbereitet, anschliessend ausgeätzt und mittels eines Plasma-Ätzprozesses wird die stromisolierende Folie (8) durch die in der mindestens einen stromleitenden Schicht (7,9) befindlichen Öffnungen (13,13', 16,16') so durchgeätzt, dass simultan eine Vielzahl von Durchganglöchern (14,14') für die Verbindung mit anderen stromleitenden Schichten (7,9) entstehen.
mittels eines weiteren Verfahrensschrittes werden Durchgangslöcher (14,14') auf mindestens eine stromleitende Schicht (7,9) des Ausgangsmateriales direkt und einmal aufplattiert, sodass Durchplattierungen (17,17') mit anderen stromleitenden Schichten (7',9') entstehen, die elektrisch miteinander verbunden sind
und mittels eines zweiten photochemischen Verfahrensschrittes wird in dieser mindestens einen vereinten stromleitenden Schicht (7',9') ein Verdrahtungsbild mit Strompfaden (18) vorbereitet und anschliessend ausgeätzt;
mittels eines folgenden Verfahrensschrittes wird das so hergestellte Halbzeug, welches das verdichtete Verdrahtungsbild trägt und geeignet ist, zu eines Leiterplatte weiterverarbeitet zu werden, mit einer unverdichteten Stromversorgungsebene, die als Serviceebene dient, zu einer Leiterplatte verbunden.

2. Verfahren nach Anspruch 1, **dadurch gekennzeichnet**, dass zur Herstellung eines mehrlagigen Halbzeuges ein gemäss dem Verfahren nach Anspruch 1 hergestelltes Halbzeug ein- oder beidseitig mit einer stromleitenden Schicht (82) belegten stromisolierenden Folie (81) auflaminiert wird,
mittels eines dritten photochemischen Verfahrensschrittes werden Öffnungen in der mindestens einen stromleitenden Schicht (82) vorbereitet und anschliessend ausgeätzt und mittels eines weiteren Plasma- Ätzprozesses werden die stromisolierende Folie (81) durch die in der mindestens einen stromleitenden Schicht (82) befindlichen Öffnungen so durchgeätzt, dass simultan eine Vielzahl von Sacklöchern für die Verbindung mit dem Verdrahtungsbild des verwendeten Halbzeuges entstehen,
mittels eines folgenden Verfahrensschrittes werden die Sacklöcher zu Durchplattierungen direkt und einmal aufplattiert, sodass stromleitende Schichten (82) und das Verdrahtungsbild des Halbzeuges elektrisch miteinander verbunden sind,
mittels eines vierten photochemischen Verfahrensschrittes wird in der mindestens einen stromleitenden Schicht (82) ein Verdrahtungsbild mit Strompfaden vorbereitet und anschliessend ausgeätzt und
mittels eines folgenden Verfahrensschrittes wird das so hergestellte mehrlagige Halbzeug, welches das Verdrahtungsbild trägt, mit einer unverdichteten Stromversorgungsebene, die als Serviceebene dient, zu einer Leiterplatte verbunden.

3. Verfahren nach Anspruch 1 oder 2, **dadurch gekennzeichnet**, dass die Durchgangslöcher (14,14') oder Sacklöcher zur Durchkontaktierung mittels eines Siebdruckverfahrens mit einem elektrisch leitenden Material gefüllt werden und das Material anschliessend verfestigt wird.

4. Verfahren nach Anspruch 1 oder 2, **dadurch gekennzeichnet**, dass die Durchgangslöcher (14,14') oder Sacklöcher zur Durchkontaktierung mittels eines Kopierverfahrens mit einem elektrisch leitenden Material gefüllt werden und das Material anschliessend verfestigt wird.

5. Verfahren nach Anspruch 1 oder 2, **dadurch gekennzeichnet**, dass stromleitende Schichten (7,9,82) des gemäss den Verfahren nach Anspruch 1 oder 2 hergestellten Halbzeuges in einem regelmässigen Muster von Durchplattierungen miteinander verbunden werden, sodass die stromleitenden Schichten (7,9,82) und das regelmässige Muster der Durchplattierungen des so hergestellten Halbzeuges ein Universalsubstrat bilden, welches ein zwischenlagerfähiges Vorfabrikat für herzustellende Leiterplatten ist und dass bei einer späteren Weiterverarbeitung die stromleitenden Schichten (7,9,82) mit einem regelmässigen Muster von Durchplattierungen in ein verdichtetes Verdrahtungsbild photochemisch strukturiert werden.

6. Verfahren nach Anspruch 1 bis 5, **dadurch gekennzeichnet**, dass die fertige, mehrschichtige Leiterplatte mit einem mechanischen Träger (20) zusammengebracht wird.

7. Verfahren nach Anspruch 1, **dadurch gekennzeichnet**, dass das Ausgangsmaterial zusammenhängend von einer Lagermenge abgezogen und zu einem Halbzeug strukturiert wird und dass das entstandene Halbzeug zur späteren Weiterverarbeitung wieder zu einer Lagermenge zusammengebracht wird.

8. Verfahren nach Anspruch 2 und 7, **dadurch gekennzeichnet**, dass mindestens eine mit einer stromleitenden Schicht (82) belegte Folie (81) und ein Halbzeug jeweils zusammenhängend von einer Lagermenge abgezogen werden, dass diese miteinander verbunden werden, dass die mindestens eine belegte Folie (81) strukturiert wird und dass das entstandene Halbzeug zur späteren Weiterverarbeitung wieder zu einer Lagermenge zusammengebracht wird.

9. Verfahren nach einem der Ansprüche 1, 2, 7 oder 8, **dadurch gekennzeichnet**, dass mindestens ein Halbzeug zusammenhängend von einer Lagermenge abgezogen, dass Halbzeuge von Rollen abgerollt oder von Faltstapeln abgenommen werden können, dass diese Halbzeuge mit Serviceebenen zu Leiterplatten verbunden werden, und dass die entstandenen Leiterplatten zur späteren Weiterverarbeitung wieder zu einer Lagermenge zusammengebracht werden.

10. Verfahren nach Anspruch 7 oder 8, **dadurch gekennzeichnet**, dass die Lagermengen Rollen oder Faltstapel sind, dass Ausgangsmaterial und mit einer stromleitenden Schichten (82) belegte Folien (81) von Rollen abgerollt werden, dass Halbzeuge von Rollen abgerollt oder von Faltstapeln abgenommen werden können und dass Halbzeuge wieder aufgerollt oder gestapelt werden.

11. Verfahren nach einem der Ansprüche 1 bis 10, **dadurch gekennzeichnet**, dass im verwendeten Folienmaterial zur Bildung eines Faltstapels Sollknickstellen hergestellt werden, indem entlang von im wesentlichen äquidistanten Linien quer zur quasi endlosen Ausdehnung des Folienmaterials mindestens eine der elektrisch isolierenden Folienlagen (8,81) mittels Ätzen derart aufbereitet wird, sodass das Folienmaterial entlang der genannten Linien bevorzugt faltbar wird.

12. Verfahren nach Anspruch 11, **dadurch gekennzeichnet**, dass in den gleichen Verfahrensschritten, in denen Durchgangslöcher (14,14') oder Sacklöcher in elektrisch isolierenden Folienlagen (8,81) des Folienmaterials erstellt werden, mindestens eine elektrisch isolierende Folienlage (8,81) des Folienmaterials zur Herstellung der Sollknickstellen durchgeätzt wird.

13. Verfahren nach einem der Ansprüche 1 bis 10, **dadurch gekennzeichnet**, dass entlang den Längskanten Transportlochreihen erstellt werden und dass quasi endloses Folienmaterial mittels einer Stachelradanordnung von Lagermenge zu Lagermenge transportiert wird.

14. Verfahren nach Anspruch 11 und 13, **dadurch gekennzeichnet**, dass in den gleichen Verfahrensschritten, in denen mindestens eine elektrisch isolierende Folienlage (8,81) zur Herstellung der Sollknickstellen geschwächt wird, auch Transportlochreihen erstellt werden.

15. Verfahren nach einem der Ansprüche 11 bis 14, **dadurch gekennzeichnet**, dass die mindestens eine elektrisch isolierende Folienlage (8,81) des Folienmaterials durch Plasmaätzen geschwächt wird.

16. Verfahren nach einem der Ansprüche 11 bis 14, **dadurch gekennzeichnet**, dass die mindestens eine elektrisch isolierende Folienlage (8,81) durch örtliches Durchätzen oder durch örtliches Anätzen geschwächt wird.

17. Leiterplatte mit extrem verdichteter Verdrahtung, hergestellt nach dem Verfahren gemäss Anspruch 1 oder 2,
**dadurch gekennzeichnet**,
dass bei beidseitig mit Stromleitenden Schichten belegten Folie die in Strompfade (18) strukrurierten stromleitenden Schichten (7,9,82) des Halbzeuges über Einzeldurchplattierungen durch die mindestens eine stromisolierende Folie (8,81) miteinander verbunden sind und dass auch bei einer Mehrzahl von strukturierten stromleitenden Schichten (7,9,82) des Halbzeuges stets nur zwei benachbarte strukturierte stromleitende Schichten (7,9,82) des Halbzeuges durch stromisolierendes Folienmaterial (8,81) hindurch stromleitverbunden sind.

18. Leiterplatte nach Anspruch 17, **dadurch gekennzeichnet**, dass eine elektrisch isolierende Folienlage (8,81) des Halbzeuges regelmässig sich wiederholende Anordnungen von Durchgangslöchern (14,14') und/oder Sacklöchern aufweist.

19. Leiterplatte nach Anspruch 17, **dadurch gekennzeichnet**, dass das Halbzeug regelmässig sich wiederholende Anordnungen von Durchplattierungen aufweist, sodass die stromleitenden Schichten (7,9,82) und das regelmässige Muster der Durchplattierungen des so hergestellten Halbzeuges ein Universalsubstrat bilden, welches ein zwischenlagerfähiges Vorfabrikat für herzustellende Leiterplatten ist und dass bei einer späteren Weiterverarbeitung die stromleitenden Schichten (7,9,82) mit einem regelmässigen Muster von Durchplattierungen in ein verdichtetes Verdrahtungsbild photochemisch strukturierbar ist.

20. Halbzeug für eine Leiterplatte mit extrem verdichteter Verdrahtung, hergestellt nach dem Verfahren gemäss Anspruch 1 oder 2,
**dadurch gekennzeichnet**,
dass die stromleitenden Schichten (7,9,82) zu vereinten stromleitenden Schichten (7',9') direkt und einmal aufplattiert sind und dass in diesen vereinten stromleitenden Schichten (7,9') ein Verdrahtungsbild mit Strompfaden (18) ausgeätzt ist.

21. Halbzeug nach Anspruch 20, **dadurch gekennzeichnet**, dass das verwendete Folienmaterial Sollknickstellen aufweist, die entlang von im wesentlichen äquidistanten Linien quer zur quasi endlosen Ausdehnung des Folienmaterials verlaufen, dass mindestens eine der elektrisch isolierenden Folienlagen (8,81) des verwendeten Folienmaterials derart geätzt ist, sodass das Folienmaterial entlang der genannten Linien bevorzugt faltbar ist.

22. Halbzeug nach Anspruch 20, **dadurch gekennzeichnet**, dass das verwendete Folienmaterial Transportlochreihen aufweist, die entlang der Längskanten parallel zur quasi endlosen Ausdehnung des Folienmaterial verlaufen, sodass das Folienmaterial mittels einer Stachelradanordnung von Lagermenge zu Lagermenge transportierbar ist.

23. Halbzeug nach Anspruch 21 oder 22, **dadurch gekennzeichnet**, dass das verwendete Folienmaterial mittels Transportlochreihen und Sollknickstellen von Lagermengen in Form von Rollen oder Faltstapeln abnehmbar ist und in Lagermengen in Form von Rollen oder Faltstapeln stapelbar ist.

## Claims

1. Process for producing multilayer circuit boards with extremely dense wiring from a starting material, using a current-insulating sheet (8) which is coated with at least one current-conducting layer (7, 9) and has a thickness of less than 500 µm,
using the following process steps:
by means of a first photochemical process step, openings (13, 13', 16, 16') are prepared in the at least one current-conducting layer (7, 9) and are then etched out, and by means of a plasma etching process, the current-insulating sheet (8) is etched through the openings (13, 13', 16, 16') in the at least one current-conducting layer (7, 9) in such a way that at the same time a large number of through-holes (14, 14') for the connection to other current-conducting layers (7, 9) are produced;
by means of a further process step, through-holes (14, 14') are plated directly and once onto the at least one current-conducting layer (7, 9) of the starting material, so that plated-through holes (17, 17') to other current-conducting layers (7', 9') are produced, these layers being connected electrically to one another;
and, by means of a second photochemical process step, a wiring pattern with current paths (18) is prepared in this at least one combined current-conducting layer (7', 9') and is then etched out;
by means of a following process step, the semifinished product which has been produced in this way, bears the compressed wiring pattern and is suitable to be processed further to form a circuit board, is combined with an uncompressed power supply plane, which is used as a service plane, to form a circuit board.

2. Process according to Claim 1, characterized in that in order to produce a multilayer semifinished product, a semifinished product produced in accordance with the process of Claim 1 is laminated on one or both sides to a current-insulating sheet (81) which is coated with a current-conducting layer (82);
by means of a third photochemical process step, openings are prepared in the at least one current-conducting layer (82) and are then etched out and, by means of a further plasma etching process, the current-insulating sheet (81) is etched through the openings in the at least one current-conducting layer (82) in such a way that at the same time a large number of blind holes for the connection to the wiring pattern of the semifinished product used are produced;
by means of a subsequent process step, the blind holes are plated over directly and once to form plated-through holes, so that current-conducting layers (82) and the wiring pattern of the semifinished product are connected electrically to each other;
by means of a fourth photochemical process step, a wiring pattern with current paths is prepared in the at least one current-conducting layer (82) and is then etched out; and
by means of a subsequent process step, the multilayer semifinished product which has been produced in this way and bears the wiring pattern is connected to an uncompressed power supply plane, which is used as a service plane, to form a circuit board.

3. Process according Claim 1 or 2, characterized in that, for the purpose of making through-contact, the through-holes (14, 14') or blind holes are filled with an electrically conductive material by means of a screen printing process and the material is then solidified.

4. Process according to Claim 1 or 2, characterized in that, for the purpose of making through-contact, the through-holes (14, 14') or blind holes are filled with an electrically conductive material by means of a copying process and the material is then solidified.

5. Process according to Claim 1 or 2, characterized in that current-conducting layers (7, 9, 82) of the semifinished product produced in accordance with the process of Claim 1 or 2 are connected to one another in a regular pattern of plated-through holes, so that the current-conducting layers (7, 9, 82) and the regular pattern of plated-through holes in the semifinished product produced in this way form a universal substrate which is a pre-product for circuit boards to be produced, which pre-product is suitable for intermediate storage, and in that, during subsequent further processing, the current-conducting layers (7, 9, 82) having a regular pattern of plated-through holes are structured photochemically to form a compressed wiring pattern.

6. Process according to Claims 1 to 5, characterized in that the finished multilayer circuit board is combined with a mechanical substrate (20).

7. Process-according to Claim 1, characterized in that the starting material is drawn off in coherent form from a storage quantity and is structured to form a semifinished product, and in that, for subsequent further processing, the semifinished product produced is recombined into a- storage quantity.

8. Process according to Claims 2 and 7, characterized in that at least one sheet (81) coated with a current-conducting layer (82), and a semifinished product are respectively drawn off in coherent form from a storage quantity, in that these are connected to each other, in that the at least one coated sheet (81) is structured and in that, for subsequent further processing, the semifinished product produced is recombined into a storage quantity.

9. Process according to one of Claims 1, 2, 7 or 8, characterized in that at least one semifinished product is drawn off in coherent form from a storage quantity, in that semifinished products can be unrolled from rolls or taken off from folded stacks, in that these semifinished products are connected to service planes to form circuit boards, and in that, for subsequent further processing, the circuit boards produced are recombined into a storage quantity.

10. Process according to Claim 7 or 8, characterized in that the storage quantities are rolls or folded stacks, in that the starting material and sheets (81) coated with a current-conducting layer (82) are unrolled from rolls, in that semifinished products can be unrolled from rolls or taken off from folded stacks, and in that semifinished products are rolled up or stacked again.

11. Process according to one of Claims 1 to 10, characterized in that intended bending locations are produced in the sheet material used to form a folded stack in that, along essentially equidistant lines transverse to the quasi-continuous extent of the sheet material, at least one of the electrically insulating sheet layers (S, 81) is prepared by etching in such a way that the sheet material becomes capable of being folded preferentially along the said lines.

12. Process according to Claim 11, characterized in that in the same process steps in which through-holes (14, 14') or blind holes are made in electrically insulating layers (8, 81) of the sheet material, at least one electrically insulating layer (8, 81) of the sheet material is etched through to produce the intended bending locations.

13. Process according to one of Claims 1 to 10, characterized in that rows of transport holes are made along the long edges, and in that quasi-continuous sheet material is transported from storage quantity to storage quantity by means of a pin-wheel arrangement.

14. Process according to Claims 11 and 13, characterized in that in the same process steps in which at least one electrically insulating sheet layer (8, 81) is weakened to produce the intended bending locations, rows of transport holes are also made.

15. Process according to one of Claims 11 to 14, characterized in that the at least one electrically insulating layer (8, 81) of the sheet material is weakened by plasma etching.

16. Process according to one of Claims 11 to 14, characterized in that the at least one electrically insulating sheet layer (8, 81) is weakened by etching through locally or by local mild etching.

17. Circuit board with extremely compressed wiring, produced in accordance with the process of Claim 1 or 2, characterized in that in the case of a sheet which is coated on both sides with current-conducting layers, those current-conducting layers (7, 9, 82) of the semifinished product which have been structured to form current paths (18) are connected to one another via individual plated-through holes through the at least one current-insulating sheet (8, 81), and in that even when there is a plurality of structured current-conducting layers (7, 9, 82) in the semifinished product, it is always only two adjacent structured current-conducting layers (7, 9, 82) in the semifinished product which are conductively connected through current-insulating sheet material (8, 81).

18. Circuit board according to Claim 17, characterized in that an electrically insulating sheet layer (8, 81) of the semifinished product has regularly repeating arrangements of through-holes (14, 14') and/or blind holes.

19. Circuit board according to Claim 17, characterized in that the semifinished product has regularly repeating arrangements of plated-through holes, so that the current-conducting layers (7, 9, 82) and the regular pattern of the plated-through holes in the semifinished product produced in this way form a universal substrate which is a pre-product for circuit boards to be produced, which pre-product is suitable for intermediate storage, and in that, during subsequent further processing, the current-conducting layers (7, 9, 82) having a regular pattern of plated-through holes can be structured photochemically to form a compressed wiring pattern.

20. Semifinished product for a circuit board having extremely compressed wiring, produced in accordance with the process of Claim 1 or 2, characterized in that the current-conducting layers (7, 9, 82) are plated on directly and once to form combined current-conducting layers (7', 9'), and in that a wiring pattern with current paths (18) is etched out in these combined current-conducting layers (7', 9').

21. Semifinished product according to Claim 20, characterized in that the sheet material used has intended bending locations which run along essentially equidistant lines transverse to the quasi-continuous extent of the sheet material, and in that at least one of the electrically insulating layers (8, 81) of the sheet material used is etched in such a way that the sheet material becomes capable of being folded preferentially along the said lines.

22. Semifinished product according to Claim 20, characterized in that the sheet material used has rows of transport holes which run along the long edges, parallel to the quasi-continuous extent of the sheet material, so that the sheet material can be transported from storage quantity to storage quantity by means of a pin-wheel arrangement.

23. Semifinished product according to Claim 21 or 22, characterized in that, by means of rows of transport holes and intended bending locations, the sheet material used can be taken off from storage quantities in the form of rolls or folded stacks, and can be stacked in storage quantities in the form of rolls or folded stacks.

## Revendications

1. Procédé pour la fabrication de circuits imprimés multicouches à câblage extrêmement compact en partant d'une matière de départ qui comprend une feuille isolante de l'électricité (8) d'une épaisseur inférieure à 500µm, revêtue d'au moins une couche conductrice de l'électricité (7,9), comprenant les étapes de procédé suivantes :
au moyen d'une première étape photochimique du procédé, des ouvertures (13,13',16,16') sont préparées dans l'au moins une couche conductrice de l'électricité (7,9), puis gravées et, au moyen d'un procédé de gravure au plasma, la feuille isolante de l'électricité (8) est traversée par gravure à travers les ouvertures (13,13',16,16') situées dans l'au moins une couche conductrice de l'électricité (7,9), de telle manière qu'il se forme simultanément une pluralité de trous traversants (14,14') pour la connexion avec d'autres couches conductrices de l'électricité (7,9),
au moyen d'une autre étape du procédé, des trous traversants (14,14') sont métallisés directement et en une seule fois sur l'au moins une couche conductrice de l'électricité (7,9) de la matière de départ, de sorte qu'il se forme des métallisations traversantes (17,17') avec d'autres couches conductrices de l'électricité (7',9') qui sont connectées électriquement entre elles,
et au moyen d'une deuxième étape photochimique du procédé, un dessin de câblage possédant des pistes conductrices (18) est préparé et ensuite gravé dans l'au moins une couche conductrice de l'électricité (7',9') réunie ;
au moyen d'une étape suivante du procédé, le semi-produit ainsi fabriqué, qui porte le dessin de câblage compacté et qui est approprié pour être transformé ensuite en un circuit imprimé, est connecté à un plan d'alimentation électrique non compacté qui sert de plan de service, pour former un circuit imprimé.

2. Procédé selon la revendication 1, caractérisé en ce que, pour fabriquer un semi-produit multicouche, un semi-produit fabriqué conformément au procédé selon la revendication 1 est stratifié, sur une face ou sur les deux faces, avec une feuille isolante de l'électricité (81), revêtue d'une couche conductrice de l'électricité (82),
au moyen d'une troisième étape photochimique du procédé, des ouvertures sont préparées dans l'au moins une couche conductrice de l'électricité (82), puis gravées, et au moyen d'un autre processus de gravure au plasma, la feuille isolante de l'électricité (81) est traversée par gravure à travers les ouvertures situées dans l'au moins une couche conductrice de l'électricité (82), de telle manière qu'il se forme simultanément un grand nombre de trous borgnes pour la connexion avec le dessin de câblage du semi-produit utilisé,
au moyen d'une étape suivante du procédé, les trous borgnes sont métallisés directement et en une seule fois pour former des métallisations traversantes, de manière que des couches conductrices de l'électricité (82) et le dessin de câblage du semi-produit soient connectés électriquement ensemble,
au moyen d'une quatrième étape photochimique du procédé, un dessin de câblage comportant des pistes conductrices est préparé dans l'au moins une couche conductrice de l'électricité (82) et ensuite gravé, et,
au moyen d'une étape suivante du procédé, le semi-produit multicouche ainsi fabriqué qui porte le dessin de câblage est assemblé à un plan d'alimentation électrique, non compacté, qui sert de plan de service, pour former un circuit imprimé.

3. Procédé selon la revendication 1 ou 2, caractérisé en ce que, pour la métallisation traversante, les trous traversants (14,14') ou les trous borgnes sont comblés d'une matière conductrice de l'électricité par un procédé d'impression à l'écran de soie, et la matière est ensuite solidifiée.

4. Procédé selon la revendication 1 ou 2, caractérisé en ce que, pour la métallisation traversante, les trous traversants (14,14') ou les trous borgnes sont comblés d'une matière conductrice de l'électricité au moyen d'un procédé de copie et la matière est ensuite solidifiée.

5. Procédé selon la revendication 1 ou 2, caractérisé en ce que des couches conductrices de l'électricité (7,9,82) du semi-produit fabriqué conformément au procédé selon la revendication 1 ou 2, sont connectées entre elles dans un motif régulier par des métallisations traversantes, de sorte que les couches conductrices de l'électricité (7,9,82) et le motif régulier des métallisations traversantes du semi-produit ainsi fabriqué forment un substrat universel qui est un précurseur apte au stockage intermédiaire pour des circuits imprimés à fabriquer et en ce que, dans un traitement complémentaire ultérieur, les couches conductrices de l'électricité (7,9,82) possédant un motif régulier de métallisations traversantes sont structurées photochimiquement en un dessin de câblage compacté.

6. Procédé selon les revendications 1 à 5, caractérisé en ce que le circuit imprimé multicouche fini est assemblé à un support mécanique (20).

7. Procédé selon la revendication 1, caractérisé en ce que la matière de départ est prise en restant d'un seul tenant dans un lot de stock et structurée pour former un semi-produit et en ce que le semi-produit obtenu est de nouveau regroupé en un lot de stock en vue du traitement complémentaire ultérieur.

8. Procédé selon les revendications 2 et 7, caractérisé en ce qu'au moins une feuille (81) revêtue d'une couche conductrice de l'électricité (82) et un semi-produit sont pris en restant d'un seul tenant dans un lot de stock, en ce que ces éléments sont assemblés entre eux, en ce que l'au moins une feuille revêtue (81) est structurée et en ce que le semi-produit ainsi obtenu est regroupé en un lot de stock en vue du traitement complémentaire ultérieur.

9. Procédé selon une des revendications 1, 2, 7 et 8, caractérisé en ce qu'au moins un semi-produit peut être pris en restant d'un seul tenant dans un lot de stock, en ce que des semi-produits peuvent être déroulés de bobines ou pris sur des empilements plissés, en ce que ces semi-produits sont assemblés avec des plans de service pour former des circuits imprimés et en ce que les circuits imprimés obtenus sont de nouveau regroupés en un lot de stock en vue du traitement complémentaire ultérieur.

10. Procédé selon la revendication 7 ou 8, caractérisé en ce que les lots de stock sont des bobines ou des empilements plissés, en ce que la matière de départ et les feuilles (81) revêtues d'une couche conductrice de l'électricité (82) sont déroulées de bobines, en ce que les semi-produits peuvent être déroulés de bobines ou pris sur des empilements plissés et en ce que les semi-produits sont de nouveau enroulés ou empilés.

11. Procédé selon une des revendications 1 à 10, caractérisé en ce que, dans la matière en feuille utilisée, sont formés des zones d'amorce de pliage pour la formation d'une empilement plissé par le fait que, le long de deux lignes sensiblement équidistantes et transversalement à la longueur quasi indéfinie de la matière en feuille, au moins une des strates de feuille isolante de l'électricité (8, 81) est préparée par gravure de telle manière que la matière en feuille puisse être pliée préférentiellement le long des lignes précitées.

12. Procédé selon la revendication 11, caractérisé en ce que, dans les mêmes étapes du procédé que celles dans lesquelles des trous traversants (14, 14') ou des trous borgnes sont formés dans des strates de feuilles isolantes de l'électricité (8, 81) de la matière en feuille, au moins une strate de feuille isolante de l'électricité de la matière en feuille est traversée par gravure pour la formation des zones d'amorce de pliage.

13. Procédé selon une des revendications 1 à 10, caractérisé en ce que des rangées de perforations de transport sont formées le long des bords longitudinaux et en ce qu'une matière en feuille quasi indéfinie est transportée d'un lot de stock à un lot de stock au moyen d'un dispositif à roues à picots.

14. Procédé selon les revendications 11 et 13, caractérisé en ce que des rangées de trous de transport sont aussi formées dans les mêmes étapes du procédé que celles dans lesquelles au moins une strate de feuille isolante de l'électricité (8, 81) est affaiblie pour la formation des zones d'amorce de pliage.

15. Procédé selon une des revendications 11 à 14, caractérisé en ce que l'au moins une strate de feuille isolante de l'électricité (8, 81) de la matière en feuille est affaiblie par gravure au plasma.

16. Procédé selon une des revendications 11 à 14, caractérisé en ce que l'au moins une strate de feuille isolante de l'électricité (8, 81) est affaiblie par gravure traversante locale ou par une amorce de gravure locale.

17. Circuit imprimé possédant un câblage extrêmement compacté, fabriqué conformément au procédé selon la revendication 1 ou 2, caractérisé en ce que, dans le cas d'une feuille revêtue de couches conductrices de l'électricité sur les deux faces, les couches conductrices de l'électricité (7,9,82) du semi-produit qui sont structurées pour former des pistes conductrices (18) sont assemblées entre elles par l'au moins une feuille isolante de l'électricité (8,81) et en ce que, même dans un semi-produit possédant une pluralité de couches conductrices de l'électricité structurées (7,9,82), il n'y a dans chaque cas que deux couches conductrices de l'électricité structurées (7,9,82) adjacentes du semi-produit qui sont connectées par une liaison conductrice de l'électricité à travers la matière en feuille isolante de l'électricité (8,81).

18. Circuit imprimé selon la revendication 17, caractérisé en ce qu'une strate de feuille isolante de l'électricité (8, 81) du semi-produit présente des groupements de trous traversants (14,14') et/ou de trous borgnes qui se répètent régulièrement.

19. Circuit imprimé selon la revendication 17, caractérisé en ce que le semi-produit présente des groupements de métallisations traversantes qui se répètent régulièrement de sorte que les couches conductrices de l'électricité (7,9,82) et le motif régulier des métallisations traversantes du semi-produit ainsi fabriqué forment un substrat universel qui est un précurseur apte au stockage intermédiaire pour des circuits imprimés à fabriquer et en ce que, dans un traitement complémentaire ultérieur, les couches conductrices de l'électricité (7,9,82) possédant un motif régulier de métallisations traversantes peuvent être structurées par voie photochimique pour former un dessin de câblage compacté.

20. Semi-produit pour un circuit imprimé possédant un câblage extrêmement compacté, fabriqué conformément au procédé selon la revendication 1 ou 2, caractérisé en ce que les couches conductrices de l'électricité (7,9,82) sont métallisées directement et en une seule fois pour former des couches conductrices de l'électricité (7',9') réunies, et en ce qu'un dessin de câblage possédant des pistes conductrices (18) est gravé dans ces couches conductrices de l'électricité réunies (7,9').

21. Semi-produit selon la revendication 20, caractérisé en ce que la matière en feuille utilisée présente des amorces de pliage qui s'étendent le long de lignes sensiblement équidistantes transversalement à la longueur quasi indéfinie de la matière en feuille, en ce qu'au moins une des strates de feuille isolante de l'électricité (8,81) de la matière en feuille utilisée est gravée de telle manière que la matière en feuille puisse se plier préférentiellement le long des lignes précitées.

22. Semi-produit selon la revendication 20, caractérisé en ce que la matière en feuille utilisée présente des rangées de trous de transport qui s'étendent le long des bords longitudinaux parallèlement à la longueur quasi indéfinie de la matière en feuille, de sorte que la matière en feuille peut être transportée de lot de stock à lot de stock au moyen d'un dispositif à roues à picots.

23. Semi-produit selon la revendication 21 ou 22, caractérisé en ce qu'au moyen des rangées de trous de transport et des amorces de pliage, la matière en feuille utilisée peut être prise dans des lots de stock sous la forme de bobines ou d'empilements plissés et être collectée en lots de stock sous la forme de bobines ou d'empilements plissés.
